(19) Europäisches Patentamt
European Patent Office
Office européen des brevets

(11) EP 4 546 988 A1

(12) EUROPEAN PATENT APPLICATION
published in accordance with Art. 153(4) EPC

(43) Date of publication:
**30.04.2025 Bulletin 2025/18**

(21) Application number: **23830965.2**

(22) Date of filing: **02.06.2023**

(51) International Patent Classification (IPC):
***H10K 50/13*** *(2023.01)* ***G09F 9/00*** *(2006.01)*
***G09F 9/30*** *(2006.01)* ***H10K 50/125*** *(2023.01)*
***H10K 59/00*** *(2023.01)* ***H10K 59/38*** *(2023.01)*
***H10K 85/30*** *(2023.01)* ***H10K 85/60*** *(2023.01)*
***H10K 101/10*** *(2023.01)* ***H10K 101/40*** *(2023.01)*

(52) Cooperative Patent Classification (CPC):
**G09F 9/00; G09F 9/30; H05B 33/02; H05B 33/12; H10K 50/10; H10K 50/125; H10K 50/13; H10K 59/00; H10K 59/10; H10K 59/38; H10K 85/30; H10K 85/60;** H10K 2101/10; H10K 2101/40

(86) International application number:
**PCT/JP2023/020567**

(87) International publication number:
**WO 2024/004515 (04.01.2024 Gazette 2024/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.06.2022 JP 2022102325**

(71) Applicant: **CANON KABUSHIKI KAISHA**
**Tokyo 146-8501 (JP)**

(72) Inventors:
- **SHIOBARA, Satoru**
  **Tokyo 146-8501 (JP)**
- **MIYASHITA, Hirokazu**
  **Tokyo 146-8501 (JP)**
- **NAGASHIMA, Hitoshi**
  **Tokyo 146-8501 (JP)**
- **NISHIDE, Yosuke**
  **Tokyo 146-8501 (JP)**

(74) Representative: **Canon Europe Limited**
**European Intellectual Property Group**
**4 Roundwood Avenue**
**Stockley Park**
**Uxbridge UB11 1AF (GB)**

# (54) ORGANIC LIGHT-EMITTING ELEMENT

(57) The present disclosure provides an organic light-emitting device which includes a light-emitting layer stack including at least two stacked light-emitting layers and in which an electron injection barrier is formed by adjusting HOMOs and LUMOs of organic compounds constituting the two light-emitting layers to expand an exciton combination region. A first light-emitting layer contains a first organic compound, a second organic compound, and a first light-emitting material, a second light-emitting layer contains the first organic compound, a third organic compound, and a second light-emitting material, and the organic light-emitting device satisfies formulas [1] and [2] below.

$$|S1L1 - S1L2| < |S1L1 - S1O1| \quad [1]$$

$$LUMOO2 > LUMOO3 \quad [2]$$

S1L1: S1 level energy of the first light-emitting material
S1L2: S1 level energy of the second light-emitting material
S1O1: S1 level energy of the first organic compound
LUMOO2: energy level of lowest unoccupied molecular orbital of the second organic compound

EP 4 546 988 A1

LUMOO3: energy level of lowest unoccupied molecular orbital of the third organic compound

FIG. 1

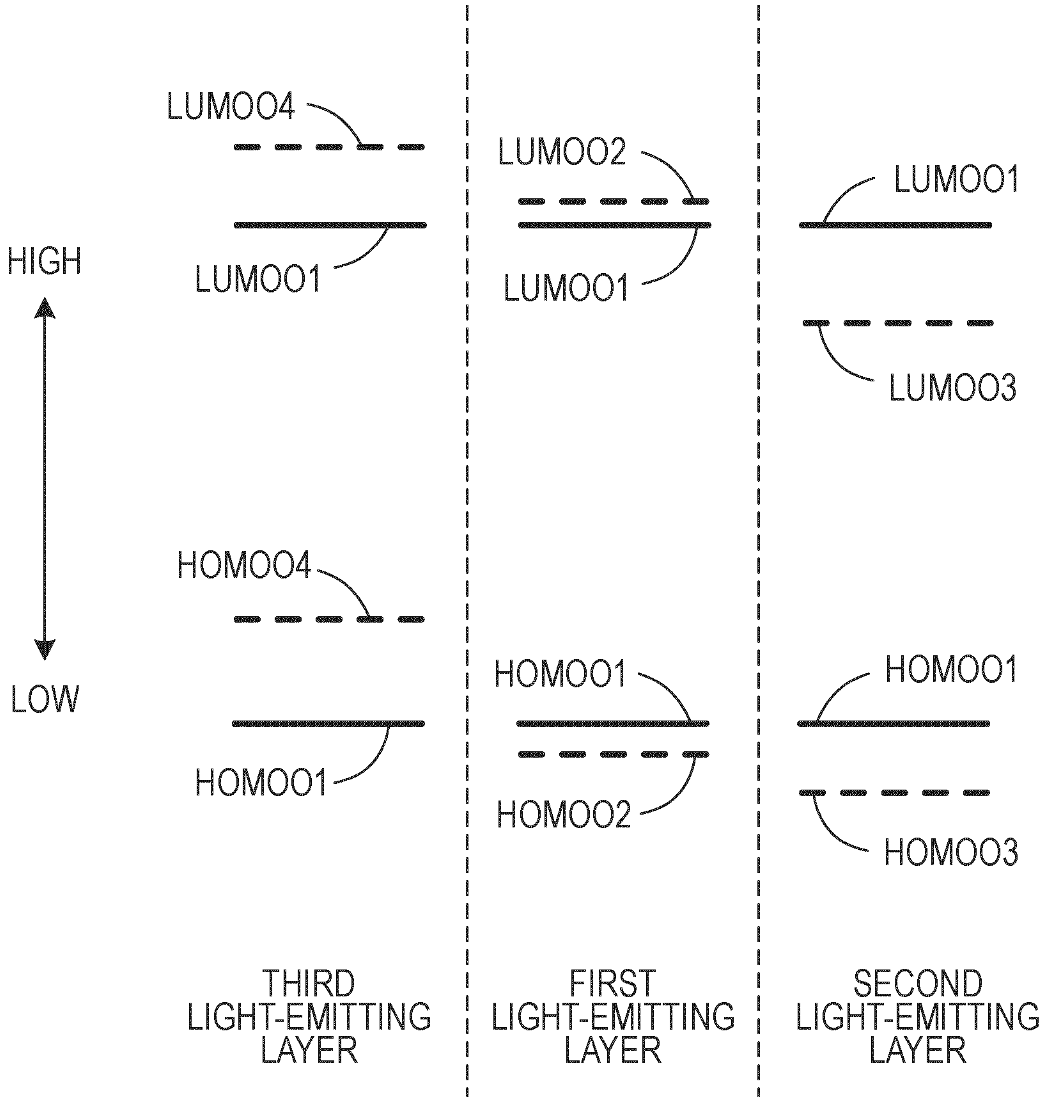

## Description

### Technical Field

The present invention relates to an organic light-emitting device and apparatuses including the organic light-emitting device.

### Background Art

An organic light-emitting device (also referred to as an "organic electroluminescence device" or "organic EL device") is an electronic device including a pair of electrodes and an organic compound layer disposed between the electrodes. The injection of electrons and holes from this pair of electrodes generates excitons of a light-emitting organic compound in the organic compound layer, and the organic light-emitting device emits light when the excitons return to the ground state.

Recently, organic light-emitting devices have been remarkably progressed, and a low drive voltage, a wide variety of emission wavelengths, a high-speed response, and a reduction in thickness and weight of light-emitting devices have been achieved.

With regard to an increase in the efficiency of light-emitting devices, devices using efficiency-improving materials, such as phosphorescent materials and delayed fluorescent materials, can be mentioned. It is known that since any of the materials has a light-emitting mechanism through the triplet excited state, the material deteriorates due to transition from the triplet excited state to a higher excited state. In such organic light-emitting devices using efficiency-improving materials that utilize the triplet excited state, improvement in the durability performance of the devices is a development subject. As for this technique, it is disclosed that the improvement is achieved by stacking light-emitting layers.

With regard to the improvement in the driving lifetime achieved by adjacent light-emitting layers, PTL 1 discloses an example in which layers containing the same light-emitting material and different host materials are stacked to form a recombination region using potential barriers due to a HOMO level difference and a LUMO level difference of the host materials. PTL 2 describes an example in which when adjacent light-emitting layers are stacked, two types of hole transport materials are mixed with a common electron transport host, and there is no injection barrier of HOMO. On the other hand, PTL 3 discloses an example in which different LUMO levels are formed with respect to the same hole transport material to form an electron injection barrier. PTL 2 and PTL 3 disclose that the fact that two host materials do not form an excited singlet during the process of forming an exciplex contributes to an increase in the lifetime. However, there is no description regarding a decrease in driving deterioration in a stack of multicolor light-emitting layers, for example, a stack of a green light-emitting layer and a red light-emitting layer.

### Citation List

### Patent Literature

PTL 1: PCT Japanese Translation Patent Publication No. 2008-509565
PTL 2: Japanese Patent Laid-Open No. 2017-152410
PTL 3: Japanese Patent Laid-Open No. 2017-183291

### Summary of Invention

### Technical Problem

To provide a display with higher luminance and higher reliability, an organic light-emitting device having a longer lifetime is necessary. In particular, in a high-efficiency organic light-emitting device using the triplet exciton of a phosphorescent material or the like, improvement in the durability performance is an issue. The organic light-emitting devices described in PTL 1 to PTL 3 are organic light-emitting devices including stacked light-emitting layers; however, there is room for improvement in the driving lifetime of such organic light-emitting devices including stacked light-emitting layers.

Solution to Problem

Accordingly, an object of the present invention is to provide an organic light-emitting device including stacked light-emitting layers and having a good driving lifetime at a high luminance.

The present invention provides an organic light-emitting device including a first electrode, a first light-emitting layer, a second light-emitting layer in contact with the first light-emitting layer, and a second electrode in this order, in which

the first light-emitting layer contains a first organic compound, a second organic compound, and a first light-emitting material,
the second light-emitting layer contains the first organic compound, a third organic compound, and a second light-emitting material, and
the organic light-emitting device satisfies formulas [1] and [2] below.

$$|S1L1 - S1L2| < |S1L1 - S1O1| \quad [1]$$

$$LUMOO2 > LUMOO3 \quad [2]$$

S1L1: S1 level energy of the first light-emitting material
S1L2: S1 level energy of the second light-emitting material
S1O1: S1 level energy of the first organic compound
LUMOO2: energy level of lowest unoccupied molecular orbital of the second organic compound
LUMOO3: energy level of lowest unoccupied molecular orbital of the third organic compound

Advantageous Effects of Invention

According to the present invention, in a light-emitting layer stack composed of at least two light-emitting layers, an electron injection barrier is formed between the light-emitting layers, and a recombination region of holes and electrons thereby expands, thus improving the durability performance of the light-emitting layers. Thus, the present invention provides an organic light-emitting device having a good driving lifetime at a high luminance and apparatuses including the organic light-emitting device.

Brief Description of Drawings

[Fig. 1] Fig. 1 is a conceptual diagram illustrating relationships of HOMOs and LUMOs of a light-emitting layer stack of an embodiment of an organic light-emitting device according to the present invention.
[Fig. 2] Fig. 2 is a conceptual diagram illustrating relationships of HOMOs and LUMOs of a light-emitting layer stack of another embodiment of the organic light-emitting device according to the present invention.
[Fig. 3] Fig. 3 is a conceptual diagram illustrating relationships of HOMOs and LUMOs of a light-emitting layer stack of another embodiment of the organic light-emitting device according to the present invention.
[Fig. 4] Fig. 4 is a conceptual diagram illustrating relationships of HOMOs and LUMOs of a light-emitting layer stack of another embodiment of the organic light-emitting device according to the present invention.
[Fig. 5] Fig. 5 is a schematic sectional view illustrating an embodiment of a display apparatus including organic light-emitting devices according to the present invention and transistors connected to the organic light-emitting devices.
[Fig. 6] Fig. 6 is a schematic view illustrating an example of a display apparatus according to an embodiment of the present invention.
[Fig. 7A] Fig. 7A is a schematic view illustrating an example of an imaging apparatus according to an embodiment of the present invention.
[Fig. 7B] Fig. 7B is a schematic view illustrating an example of an electronic apparatus according to an embodiment of the present invention.
[Fig. 8A] Fig. 8A is a schematic view illustrating an example of a display apparatus according to an embodiment of the present invention.
[Fig. 8B] Fig. 8B is a schematic view illustrating an example of a foldable display apparatus.
[Fig. 9A] Fig. 9A is a schematic view illustrating an example of an illumination apparatus according to an embodiment of the present invention.
[Fig. 9B] Fig. 9B is a schematic view illustrating an example of a moving object including a vehicle lighting fixture

according to an embodiment of the present invention. Description of Embodiments

The present invention is an invention for providing an organic light-emitting device with a long lifetime. To achieve an increase in the lifetime of an organic light-emitting device, it is necessary to reduce the deterioration of an organic material, in particular, an organic material used for a light-emitting layer, in the device. In general, to increase the lifetime of an organic light-emitting device, it is effective to expand a recombination region of electrons and holes to reduce the deterioration caused by the concentration of exciton generation. The concentration of exciton generation causes energy transfer to a molecule in an excited state from a molecule in another excited state and causes transition to a higher energy state. In a high energy state, if the binding energy of a single bond site in the molecular structure is exceeded, the bond is cleaved to generate a decomposed product, resulting in degradation of the luminance. To avoid this, it is effective to disperse exciton generation. Among several methods to cause the dispersion, a method for dispersing recombination points of electrons and holes by dividing a light-emitting layer to increase the number of light-emitting interfaces is considered to be effective in the present invention.

An organic light-emitting device according to the present invention includes, as a basic configuration, a first electrode, a first light-emitting layer, a second light-emitting layer in contact with the first light-emitting layer, and a second electrode in this order. That is, at least light-emitting layers are formed of a light-emitting layer stack in which at least two light-emitting layers are stacked in contact with each other. The first light-emitting layer contains a first organic compound as a host material, a second organic compound as an assist material, and a first light-emitting material as a light-emitting material. The second light-emitting layer contains the first organic compound as a host material, a third organic compound as an assist material, and a second light-emitting material as a light-emitting material. The organic light-emitting device according to the present invention satisfies formulas [1] and [2] below.

$$|S1L1 - S1L2| < |S1L1 - S1O1| \quad [1]$$

$$LUMOO2 > LUMOO3 \quad [2]$$

S1L1: S1 level energy of the first light-emitting material
S1O1: S1 level energy of the first organic compound
LUMOO2: energy level of lowest unoccupied molecular orbital of the second organic compound
LUMOO3: energy level of lowest unoccupied molecular orbital of the third organic compound

Since the organic light-emitting device according to the present invention satisfies the formula [1], energy transfer is more likely to occur between the first light-emitting layer and the second light-emitting layer than between the host material and the light-emitting material in the first light-emitting layer. Furthermore, since the organic light-emitting device satisfies the formula [2], an electron injection barrier from the second light-emitting layer to the first light-emitting layer is formed between the first light-emitting layer and the second light-emitting layer, and a recombination region expands.

In the present invention, the organic light-emitting device preferably includes a third light-emitting layer containing the first organic compound as a host material and a third light-emitting material as a light-emitting material, the third light-emitting layer being disposed on the first electrode side in contact with the first light-emitting layer. The third light-emitting layer preferably further contains a fourth organic compound as an assist material. When the first light-emitting layer and the second light-emitting layer have the same emission color, the third light-emitting layer has an emission color different from the emission color of the first light-emitting layer and the second light-emitting layer. In the present invention, yellow light is emitted by green light emission and red light emission. Thus, when the first light-emitting layer and the second light-emitting layer emit green light or red light, the third light-emitting layer emits red light or green light. When the first light-emitting layer and the second light-emitting layer have different emission colors, the emission color of the third light-emitting layer may be the same as either emission color.

In the present invention, further, a formula [3] below and still further, a formula [4] below are preferably satisfied because energy easily flows from the light-emitting material of the first light-emitting layer to the light-emitting material of the third light-emitting layer.

$$S1L3 < S1L1 \quad [3]$$

$$HOMOL3 < HOMOL1 \quad [4]$$

S1L3: S1 level energy of the third light-emitting material
HOMOL1: energy level of highest occupied molecular orbital of the first light-emitting material

HOMOL3: energy level of highest occupied molecular orbital of the third light-emitting material

In the present invention, a formula [5] below is preferably satisfied because durability of light-emitting materials is enhanced to improve the lifetime of the organic light-emitting device.

$$LUMOL3 < LUMOL1 \quad [5]$$

LUMOL1: energy level of lowest unoccupied molecular orbital of the first light-emitting material
LUMOL3: energy level of lowest unoccupied molecular orbital of the third light-emitting material

In the present invention, formulas [6] to [8] below are preferably further satisfied.

$$LUMOO1 > LUMOO3 \quad [6]$$

$$HOMOO4 > HOMOO1 \quad [7]$$

$$HOMOO4 > HOMOO2 \quad [8]$$

LUMOO1: energy level of lowest unoccupied molecular orbital of the first organic compound
LUMOO3: energy level of lowest unoccupied molecular orbital of the third organic compound
HOMOO1: energy level of highest occupied molecular orbital of the first organic compound
HOMOO4: energy level of highest occupied molecular orbital of the fourth organic compound
HOMOO2: energy level of highest occupied molecular orbital of the second organic compound

Furthermore, in the present invention, at least one of formulas [9] and [10] below is preferably satisfied because the drive voltage of the organic light-emitting device can be reduced.

$$LUMOO1 > LUMOO2 \quad [9]$$

$$HOMOO2 > HOMOO1 \quad [10]$$

LUMOO1: energy level of lowest unoccupied molecular orbital of the first organic compound
LUMOO2: energy level of lowest unoccupied molecular orbital of the second organic compound
HOMOO1: energy level of highest occupied molecular orbital of the first organic compound
HOMOO2: energy level of highest occupied molecular orbital of the second organic compound

Hereinafter, the operation of expanding a recombination region of electrons and holes in the present invention and preferred embodiments will be described with reference to Figs. 1 to 4 using, as an example, a light-emitting layer stack in which three light-emitting layers are stacked. Light-emitting pixels used for a display mainly require light-emitting devices that exhibit red, green, and blue emission colors. The light-emitting devices have a configuration in which light-emitting layers are formed in accordance with the emission color of each light-emitting pixel or a configuration in which a color filter is provided on devices that emit white light. A generally possible configuration is one in which blue light emission and yellow light emission are combined when white light is emitted.

A yellow light-emitting layer in the light-emitting layers exhibits yellow by emitting light of two colors (red and green) for the purpose of expanding the color reproduction range as a display; however, the degradation rate of red light emission and the degradation rate of green light emission are usually different. A light-emitting layer that exhibits green light emission is more likely to degrade than a light-emitting layer that exhibits red light emission because the energy level of an exciton utilized is also high. Meanwhile, when the above yellow light-emitting device is used for a display or another light-emitting device, the luminance degradation time of red light emission and the luminance degradation time green light emission are different, resulting in a problem of the occurrence of a color shift during driving of the device. This color shift due to driving deterioration of the organic light-emitting device that exhibits yellow light emission becomes a problem, in particular, for example, when the organic light-emitting device is used in a white light-emitting device in which a blue light-emitting device and a yellow light-emitting device are connected together in a tandem device structure.

The light-emitting layer stack of the present embodiment includes the third light-emitting layer, the first light-emitting layer, and the second light-emitting layer, the third light-emitting layer is disposed on a hole injection electrode

side, and the second light-emitting layer is disposed on an electron injection electrode side. The light-emitting layers each contain a red or green light-emitting material (guest). The light-emitting layers include at least one red light-emitting layer and at least one green light-emitting layer, and each contain the first organic compound as a host material and any of the second to fourth organic compounds as an assist material. Accordingly, the light-emitting layers have the following configurations.

First light-emitting layer: first organic compound, second organic compound, and first light-emitting material Second light-emitting layer: first organic compound, third organic compound, and second light-emitting material Third light-emitting layer: first organic compound, fourth organic compound, and third light-emitting material

In the present embodiment, the host is a compound having the highest mass ratio among compounds constituting a light-emitting layer. The guest is a compound that has a lower mass ratio than the host among the compounds constituting the light-emitting layer and that is responsible for main light emission. The assist material is a compound that has a lower mass ratio than the host among the compounds constituting the light-emitting layer and that assists the light emission of the guest. The assist material is also referred to as a second host.

One feature of the present embodiment is that the first organic compound is used as the host material of each of the light-emitting layers in common. The host material is responsible for the function as a matrix in the light-emitting layer and for charge transport. Since the first organic compound serves as a main material, the first organic compound preferably has a high glass transition temperature. In the case where the light-emitting materials include a phosphorescent material or a thermally activated delayed fluorescent material, the lowest triplet state (T1) of the first organic compound needs to be higher than a high T1 level of the contained light-emitting material, and thus the band gap is necessarily wide. The content of each of the second, third, and fourth organic compounds serving as assist materials in the light-emitting layers is required to be at least 10% by mass or more, preferably, about 20% by mass to 35% by mass, so that the organic compound functions as an assist for a carrier transport.

Since the first organic compound is used as the host material of each of the first to third light-emitting layers, with regard to the formation of the light-emitting layer stack, it is possible to contribute to a reduction in the evaporation source in an evaporation chamber of an evaporation apparatus during production. In addition, since a layer containing no light-emitting material is not provided between the light-emitting layers, generated excitons can be utilized without any surplus.

Figs. 1 to 4 illustrate relationships between energy levels of HOMO and LUMO of each of the first organic compound and the second to fourth organic compounds in the light-emitting layer stack of the present embodiment. The relationships illustrated in Figs. 1 to 4 are distinguished by the second organic compound contained in the first light-emitting layer. In Figs. 1 to 4 and the following description, HOMO represents the energy level of the highest occupied molecular orbital, and LUMO represents the energy level of the lowest unoccupied molecular orbital. O1 represents the first organic compound, O2 represents the second organic compound, O3 represents the third organic compound, O4 represents the fourth organic compound, L1 represents the first light-emitting material, L2 represents the second light-emitting material, and L3 represents the third light-emitting material.

In the present embodiment, the fourth organic compound contained in the third light-emitting layer on the hole injection electrode side assists hole transport, and the relationship between the HOMO of the first organic compound and the HOMO of the fourth organic compound is as follows.

$$\mathrm{HOMOO4} > \mathrm{HOMOO1} \qquad [7]$$

The third organic compound contained in the second light-emitting layer on the electron injection electrode side assists electron transport, and the relationship between the LUMO of the first organic compound and the LUMO of the third organic compound is as follows.

$$\mathrm{LUMOO1} > \mathrm{LUMOO3} \qquad [6]$$

Moreover, HOMOs and LUMOs of the second organic compound, the third organic compound, and the fourth organic compound have the following relationships.

$$\mathrm{LUMOO2} > \mathrm{LUMOO3} \qquad [2]$$

$$\mathrm{HOMOO4} > \mathrm{HOMOO2} \qquad [8]$$

Fig. 1 illustrates a case where the second organic compound contained in the first light-emitting layer is involved in neither hole transport nor electron transport, and the relationships between HOMOs and LUMOs of the first organic compound and the second organic compound are as follows.

HOMOO2 < HOMOO1 (does not assist hole transport)
LUMOO1 < LUMOO2 (does not assist electron transport)

In this case, the level difference from HOMOO4 to HOMOO1 is the hole injection barrier from the third light-emitting layer to the first light-emitting layer, and the level difference from LUMOO3 to LUMOO1 is the electron injection barrier from the second light-emitting layer to the first light-emitting layer.

Fig. 2 illustrates a case where the second organic compound contained in the first light-emitting layer does not assist hole transport but assists electron transport, and the relationships between HOMOs and LUMOs of the first organic compound and the second organic compound are as follows.
HOMOO2 < HOMOO1 (does not assist hole transport)

LUMOO1 > LUMOO2 (assists electron transport) [9]

In this case, the level difference from HOMOO4 to HOMOO1 is the hole injection barrier from the third light-emitting layer to the second light-emitting layer, and the level difference from LUMOO3 to LUMOO2 is the electron injection barrier from the second light-emitting layer to the first light-emitting layer.

Fig. 3 illustrates a case where the second organic compound contained in the first light-emitting layer assists hole transport and assists electron transport, and the relationships between HOMOs and LUMOs of the first organic compound and the second organic compound are as follows.

HOMOO2 > HOMOO1 (assists hole transport) [10]

LUMOO1 < LUMOO2 (does not assist electron transport)

In this case, the level difference from HOMOO4 to HOMOO2 is the hole injection barrier from the third light-emitting layer to the first light-emitting layer, and the level difference from LUMOO3 to LUMOO1 is the electron injection barrier from the second light-emitting layer to the first light-emitting layer.

Fig. 4 illustrates a case where the second organic compound contained in the first light-emitting layer assists both hole transport and electron transport, and the relationships between HOMOs and LUMOs of the first organic compound and the second organic compound are as follows.

HOMOO2 > HOMOO1 (assists hole transport) [10]

LUMOO1 > LUMOO2 (assists electron transport) [9]

In this case, the level difference from HOMO4 to HOMO2 is the hole injection barrier from the third light-emitting layer to the first light-emitting layer, and the level difference from LUMOO3 to LUMOO2 is the electron barrier from the second light-emitting layer to the first light-emitting layer.

In any of the cases illustrated in Figs. 1 to 4, the presence of the hole and electron injection barriers to the second light-emitting layer expands the recombination region and can reduce the deterioration due to the concentration of exciton generation. According to an embodiment of the present invention, it is possible to provide a light-emitting device including, in particular, a long-lifetime yellow light-emitting layer in which red and green phosphorescent materials are used for light-emitting layers. Therefore, an organic light-emitting device that mainly exhibits yellow light emission has a prolonged lifetime. In addition, improvement can be achieved so that a color shift does not occur with driving deterioration.

In the light-emitting layer stack of the present embodiment, charge injection barriers from each of the second light-emitting layer and the third light-emitting layer to the first light-emitting layer are formed in each of the layers that contain the first organic compound in common. In this case, further improvement in the durability performance can be expected when the first organic compound has a skeleton that is resistant to decomposition. For the skeleton that is resistant to decomposition, specifically, it is important that all single bonds that bind fused polycyclic skeletons be carbon-carbon bonds with high binding energy. This is because, as illustrated below with regard to examples of binding energy, when, for example, a carbon-nitrogen bond is provided as a bond between fused polycyclic skeletons, the bond is easily broken in a higher excitation energy state generated by a certain concentration of exciton generation.

[Chem. 1]

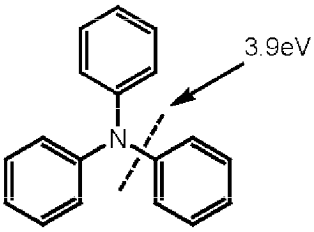


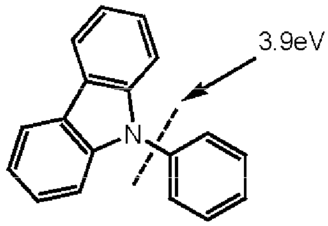


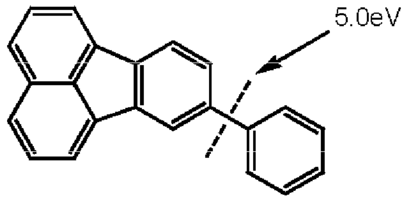


Meanwhile, the first organic compound needs to not only confine, as a host material, energy in the light-emitting materials but also be responsible for hole transport and electron transport. However, while the second to fourth organic compounds are each responsible for hole transport or electron transport as assist materials to thereby make use of the strong host material, carrier barriers can be generated at the interfaces between the stacked light-emitting layers. Therefore, this is a more preferred form for improving the durability performance of the organic light-emitting device by expanding the recombination region.

Examples of light-emitting materials in the present embodiment include, but are not limited to, fluorescent materials, phosphorescent materials, and thermally activated delayed fluorescent materials. Fluorescent materials are light-emitting materials in which radiative transition from the excited singlet state to the ground state occurs. In contrast, phosphorescent materials are materials in which radiative transition from the lowest triplet state to the ground state occurs. Thermally activated delayed fluorescent materials are materials in which radiative transition from the excited singlet state to the ground state occurs from the lowest triplet state through a reverse intersystem crossing process due to thermal excitation.

In the present embodiment, a green light-emitting material refers to a light-emitting material having a peak wavelength in the range of 500 nm to 560 nm in a photoluminescence spectrum. A red light-emitting material refers to a light-emitting material having a peak wavelength in the range of 600 nm to 650 nm in a photoluminescence spectrum. A blue light-emitting material refers to a material having a peak wavelength in the range of 440 nm to 480 nm in a photoluminescence spectrum.

In the present embodiment, the light-emitting materials are preferably phosphorescent materials or thermally activated delayed fluorescent materials in view of light emission efficiency of the organic light-emitting device. These materials have a light emission mechanism through the lowest triplet state; therefore, if exciton generation is concentrated, triplet excitons (T1), which have a long excitation lifetime, collide with each other, and consequently, triplet-triplet annihilation tends to occur. If this phenomenon occurs, a higher triplet excited state is generated with a certain probability. In addition, the occurrence of transient absorption, in which a molecule in the triplet excited state absorbs green light or red light emitted also generates a higher triplet excited state. These cause deterioration of the materials. In a state of a high current density, excessive exciton generation occurs; therefore, it is considered that similar deterioration can occur not only in light-emitting materials but also in host materials and assist materials. Accordingly, in the present embodiment, light-emitting materials such as phosphorescent materials or delayed fluorescent materials are more effective, and all of the first light-emitting material, the second light-emitting material, and the third light-emitting material are preferably phosphorescent materials. The concentration of a light-emitting material contained in a light-emitting layer is preferably 0.1% by mass to 15% by mass, but the present embodiment is not particularly limited thereto.

The light-emitting layer stack according to the present embodiment may include a fourth light-emitting layer that emits blue light and a charge generation layer between the first electrode and the light-emitting layer stack or between the second electrode and the light-emitting layer stack. The charge generation layer provides the function as a tandem device: An electron generated in the charge generation layer and a hole injected from the first electrode are subjected to charge recombination to generate an exciton, and a hole generated in the charge generation layer and an electron injected from the second electrode are subjected to charge recombination to generate an exciton. Therefore, the internal quantum efficiency is doubled. In such a case, the organic light-emitting device of the present embodiment can be used on one side of the tandem device as a yellow light-emitting layer serving as a complementary color of blue light emission. Accordingly, a tandem device configuration obtained by using the light-emitting layer stack according to the present embodiment together with a blue light-emitting layer enables a white light-emitting device to be provided. The blue light-emitting layer contains at least an organic compound serving as a host material and an organic compound which is a blue light-emitting material.

The white light-emitting device is applicable to, for example, a display or an illumination. At this time, in the case of improving the durability performance of the yellow light-emitting layer, in particular, in the case where the luminance degradation time is different between a green emission color and a red emission color, the present embodiment is preferably applied to the color with the shorter luminance degradation time. In blue, green, and red in the case of white light

emission, when, for example, luminance degradation of green light emission is the fastest, the emission color is likely to change from white to yellowish white. This may cause image-sticking on a display. Use of the organic light-emitting device of the present embodiment has an effect of reducing the time taken for causing this image-sticking. In the case where yellow light emission is caused by red light emission and green light emission with phosphorescent materials or thermally activated delayed fluorescent materials, green light emission, which utilizes more energy, is likely to undergo luminance degradation. Thus, when an organic light-emitting device that emits yellow light from red and green light-emitting layers is used and constitutes a tandem device with a blue light-emitting device to emit white light, it is necessary to improve the luminance degradation lifetime of green. Therefore, two of the three light-emitting layers of the present embodiment preferably contain a light-emitting material that emits green light.

A feature of the present embodiment lies in that recombination regions are dispersed by creating energy barriers between three adjacent light-emitting layers, the energy barriers being constituted by HOMOs and LUMOs of the first to fourth organic compounds, to prevent the concentration of excitons. The feature lies in that, in that case, the strength of the first organic compound is utilized to produce the effect of improving the driving lifetime of green and red emission colors. Combinations of the emission colors are as follows.

[Table 1]

| Combination | PL peak of first light-emitting material | PL peak of second light-emitting material | PL peak of third light-emitting material |
|---|---|---|---|
| RGG | Red | Green | Green |
| RRG | Red | Red | Green |
| RGR | Red | Green | Red |
| GRR | Green | Red | Red |
| GRG | Green | Red | Green |
| GGR | Green | Green | Red |

In contrast to this, there are innumerable combinations of the film thickness configuration, but the following are given as examples. The unit of the film thickness in Table 2 is nm. Since the film thickness is proportional to the amount of light emitted from the corresponding light-emitting layer in an organic light-emitting device, the film thicknesses are changed as appropriate when the balance of the emission colors is necessary.

[Table 2]

| Film thickness configuration | Thickness of first light-emitting layer | Thickness of second light-emitting layer | Thickness of third light-emitting layer |
|---|---|---|---|
| Thickness-A | 10 | 10 | 10 |
| Thickness-B | 5 | 10 | 15 |
| Thickness-C | 15 | 10 | 5 |
| Thickness-D | 10 | 5 | 15 |
| Thickness-E | 15 | 5 | 10 |

[Layer configuration]

Next, layers of the organic light-emitting device of the present embodiment will be described.

The layer configuration of the organic light-emitting device of the present embodiment is not particularly limited. For example, a configuration of first electrode/hole injection layer/hole transport layer/electron-blocking layer/light-emitting layer stack/hole-blocking layer/electron transport layer/electron injection layer/second electrode will be described as an example.

A hole injection/transport material that forms the hole injection layer or the hole transport layer is preferably a material that facilitates injection of holes from the anode and that has a high hole mobility so as to transport the injected holes to a light emitting layer. In addition, the hole injection/transport material is preferably a material having a high glass transition temperature in order to reduce degradation of the film quality, such as crystallization, in the organic light-emitting device. Examples of low-molecular-weight or high-molecular-weight materials having such a hole injection/transport

performance include triaryl amine derivatives, aryl carbazole derivatives, phenylenediamine derivatives, stilbene derivatives, phthalocyanine derivatives, porphyrin derivatives, poly(vinylcarbazole), poly(thiophene), and other conductive polymers. Furthermore, the above hole injection/transport materials are also suitable for use in the electron-blocking layer.

Specific examples of compounds used as the hole injection/transport material are illustrated below; however, in the present embodiment, the hole injection/transport material is not limited to these.

[Chem. 2]

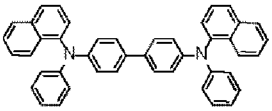
HT1

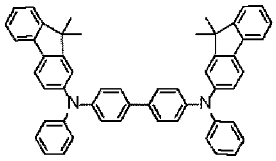
HT2

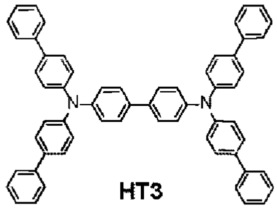
HT3

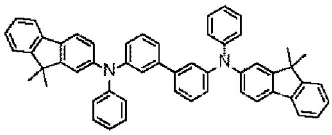
HT4

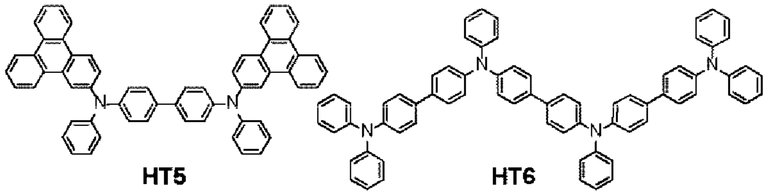
HT5

HT6

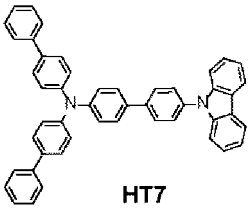
HT7

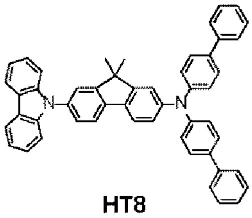
HT8

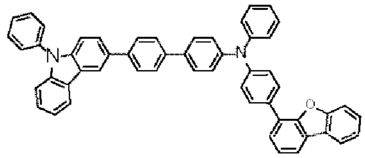
HT9

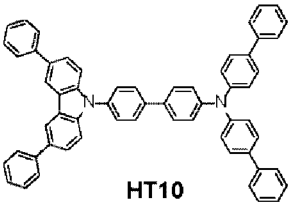
HT10

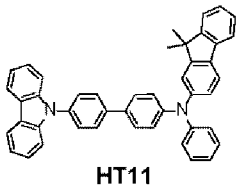
HT11

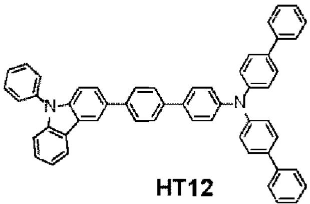
HT12

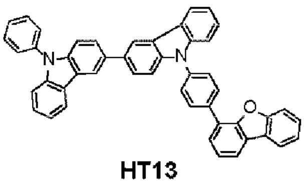
HT13

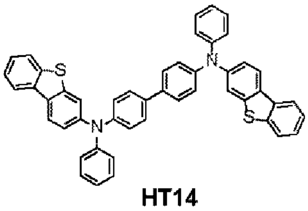
HT14

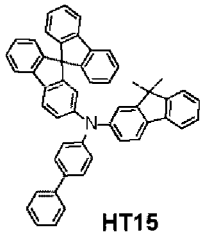
HT15

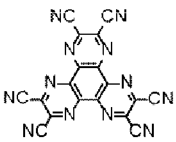
HT16

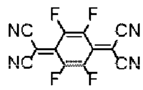
HT17

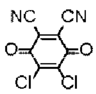
HT18

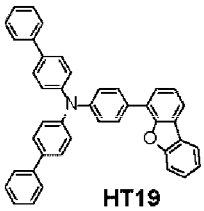
HT19

Among the hole injection/transport materials illustrated above, HT16 to HT18 can be used for the layer in contact with the anode to reduce the drive voltage. HT16 is widely used in organic light-emitting devices. HT2, HT3, HT4, HT5, HT6, HT10, and HT12 may be used for an organic compound layer adjacent to HT16. A plurality of materials may be used for a single organic compound layer.

In the present embodiment, the fourth organic compound is preferably a hole transport material. The fourth organic compound is not particularly limited as long as it is an organic compound having a hole transportability. For

example, among the above compounds, materials except for HT16, HT17, and HT18 are each preferred as a hole transport material serving as the fourth organic compound in the present embodiment. The second organic compound, as well as the fourth organic compound, may also be a hole transport material.

Examples of light-emitting materials that mainly relate to the function of light emission include fused ring compounds (such as fluorene derivatives, naphthalene derivatives, pyrene derivatives, perylene derivatives, tetracene derivatives, anthracene derivatives, and rubrene), quinacridone derivatives, coumarin derivatives, stilbene derivatives, organoaluminum complexes such as tris(8-quinolinolato) aluminum, iridium complexes, platinum complexes, rhenium complexes, copper complexes, europium complexes, ruthenium complexes, and polymer derivatives such as poly(phenylene vinylene) derivatives, poly(fluorene) derivatives, and poly(phenylene) derivatives.

Specific examples of compounds used as the light-emitting materials are illustrated below, but of course, the light-emitting materials are not limited thereto.

[Chem. 3]

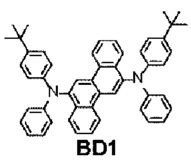
BD1
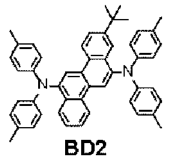
BD2
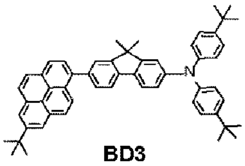
BD3
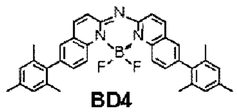
BD4

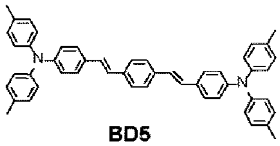
BD5
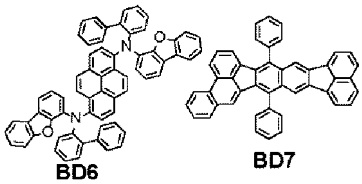
BD6
BD7
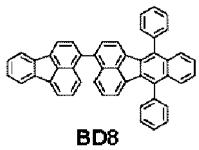
BD8

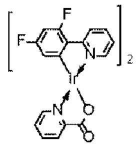
BD9
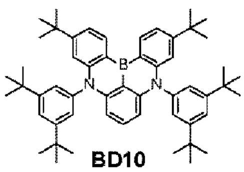
BD10

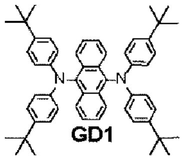
GD1
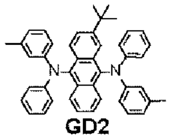
GD2
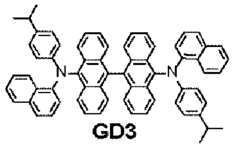
GD3
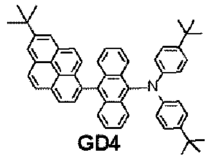
GD4

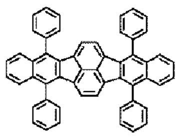
GD5
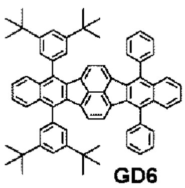
GD6
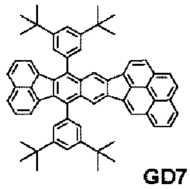
GD7
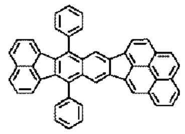
GD8

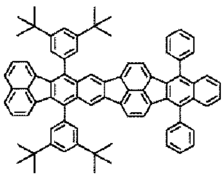
GD9
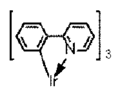
GD10
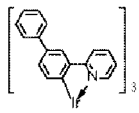
GD11
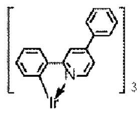
GD12

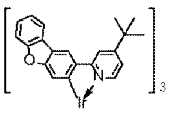
GD13
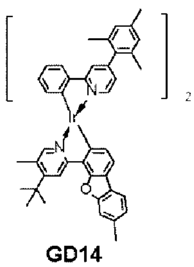
GD14
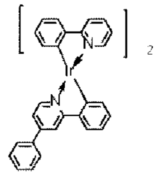
GD15

[Chem. 4]

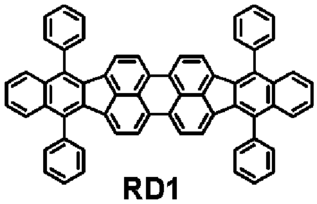
RD1

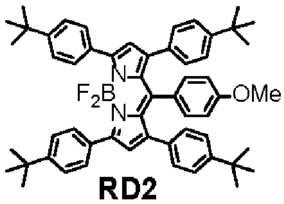
RD2

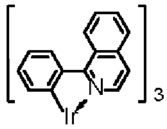
RD3

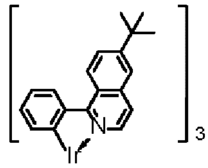
RD4

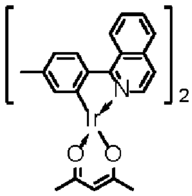
RD5

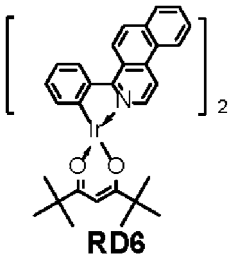
RD6

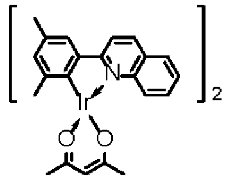
RD7

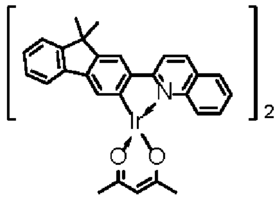
RD8

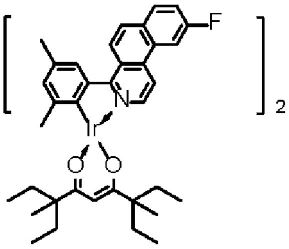
RD9

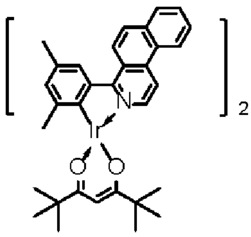
RD10

For the light-emitting materials, in order to realize a longer driving lifetime, the single bonds of rings of a fused polycyclic structure are preferably carbon-carbon bonds as in the first organic compound. Hydrocarbon compounds are compounds composed only of carbon and hydrogen, and BD7, BD8, GD5 to GD9, and RD1 correspond to such compounds. These light-emitting materials are fused polycyclic compounds including a five-membered ring, have a high ionization potential, and thus are less likely to be oxidized. Accordingly, these light-emitting materials are more preferred because they provide a highly durable device with a long lifetime. BD7, BD8, GD5 to GD9, and RD1 correspond to such compounds.

The first organic compound contained in the light-emitting layers is preferably a compound with good durability as a host material of the light-emitting layers. Examples of such a compound include, in addition to aromatic hydrocarbon compounds and derivatives thereof, carbazole derivatives, dibenzofuran derivatives, dibenzothiophene derivatives, organoaluminum complexes such as tris(8-quinolinolato)aluminum, and organoberyllium complexes.

Specific examples of the first organic compound contained in the light-emitting layers in the present embodiment are illustrated below, but of course, the first organic compound is not limited thereto.

[Chem. 5]

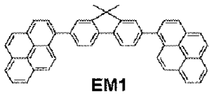
EM1
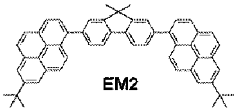
EM2
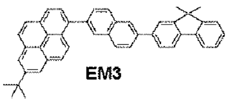
EM3
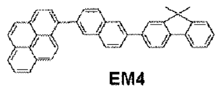
EM4
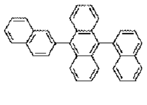
EM5
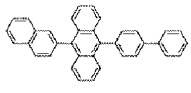
EM6
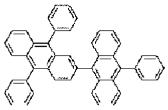
EM7
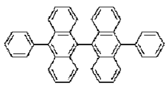
EM8
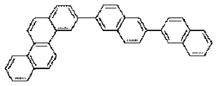
EM9
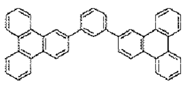
EM10
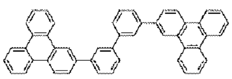
EM11
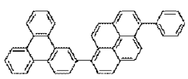
EM12
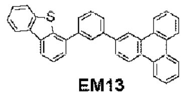
EM13
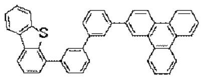
EM14
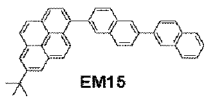
EM15
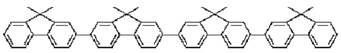
EM16
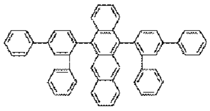
EM17
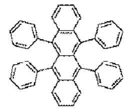
EM18
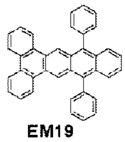
EM19
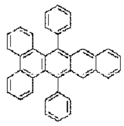
EM20
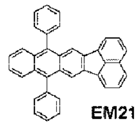
EM21
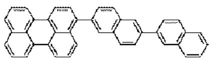
EM22
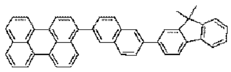
EM23
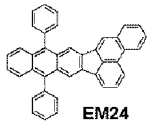
EM24
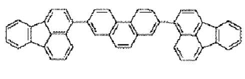
EM25
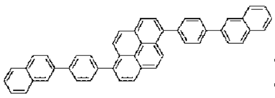
EM26
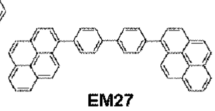
EM27
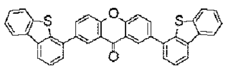
EM28
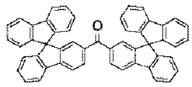
EM29
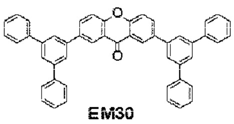
EM30
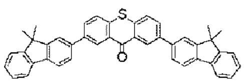
EM31
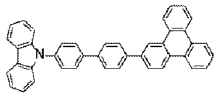
EM32
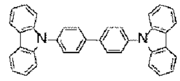
EM33
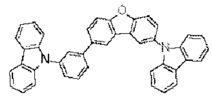
EM34
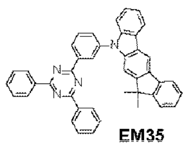
EM35
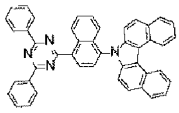
EM36
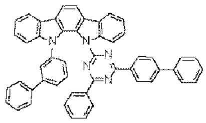
EM37
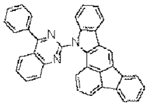
EM38
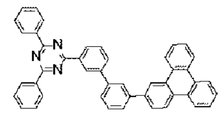
EM39
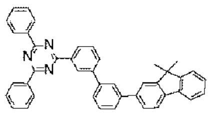
EM40

When the host material of the light-emitting layers serving as the first organic compound is a hydrocarbon compound, the light-emitting layers easily trap electrons and holes, and thus the effect of increasing the efficiency is significant, which is preferable. Hydrocarbon compounds are compounds composed only of carbon and hydrogen, and EM1 to EM12 and EM15 to EM27 correspond to hydrocarbon compounds. As the host material, a material having no carbon-heteroatom bond in the single bond connecting aryl group units in its structure is more preferable from the viewpoint of stability.

An electron transport material that forms the electron transport layer can be freely selected from materials capable of transporting electrons injected from the cathode to a light-emitting layer and is selected in consideration of, for example, the balance with the hole mobility of the hole injection/transport material. Examples of materials having an electron transportability include oxadiazole derivatives, oxazole derivatives, pyrazine derivatives, triazole derivatives, triazine derivatives, quinoline derivatives, quinoxaline derivatives, phenanthroline derivatives, organoaluminum complexes, and fused ring compounds (such as fluorene derivatives, naphthalene derivatives, chrysene derivatives, and anthracene derivatives). The above electron transport materials are also suitable for use in the hole-blocking layer.

Specific examples of compounds used as the electron transport material are illustrated below; however, in the present embodiment, the electron transport material is not limited to these.

[Chem. 6]

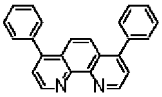
ET1
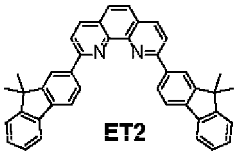
ET2
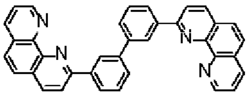
ET3
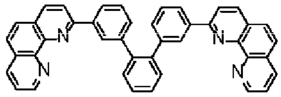
ET4
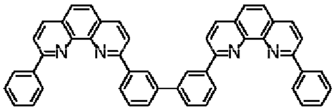
ET5
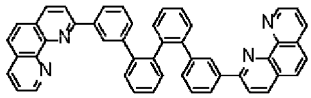
ET6
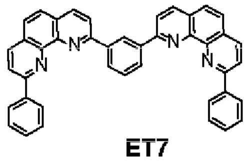
ET7
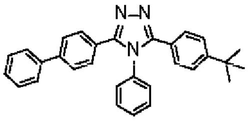
ET8
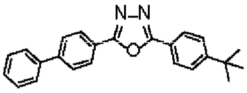
ET9
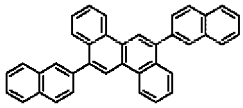
ET10
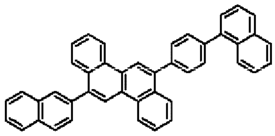
ET11
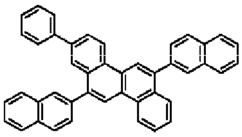
ET12
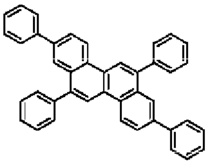
ET13
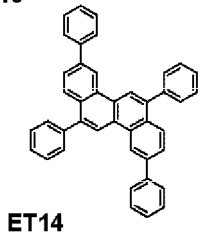
ET14
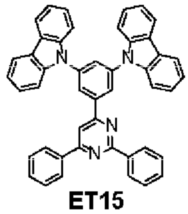
ET15
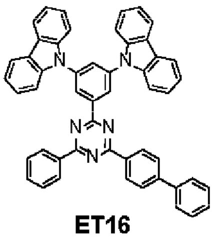
ET16
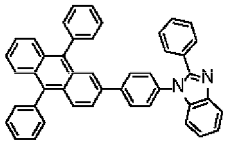
ET17
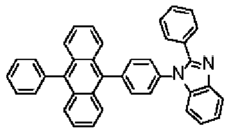
ET18
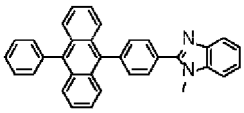
ET19
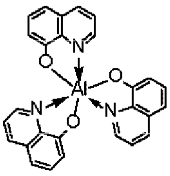
ET20
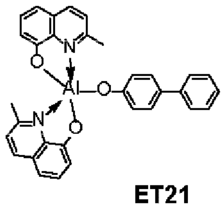
ET21
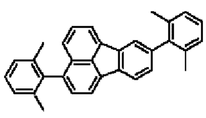
ET22
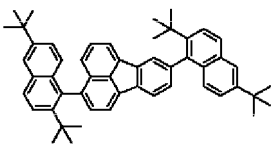
ET23

An electron injection material that forms the electron injection layer can be freely selected from materials capable of easily injecting electrons from the cathode and is selected in consideration of, for example, the balance with hole injectability. As the organic compound, n-type dopants and reducing dopants are also contained. Examples thereof include alkali metal-containing compounds such as lithium fluoride, lithium complexes such as lithium quinolinol, benzimidazolidene derivatives, imidazolidene derivatives, fulvalene derivatives, and acridine derivatives.

On the other hand, in the present embodiment, the above electron transport material is preferred as a material that assists the electron transportability as the second organic compound or the third organic compound. In that case, the electron transport compound is not limited to any of the above compounds.

Examples of the first to fourth organic compounds used for the light-emitting layer stack of the present embodiment include the following organic compounds besides the compounds listed above.

[Chem. 7]

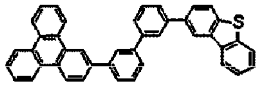

Z-1

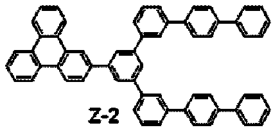

Z-2

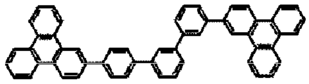

Z-3

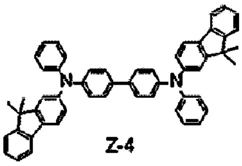

Z-4

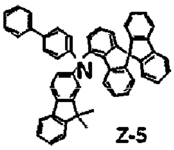

Z-5

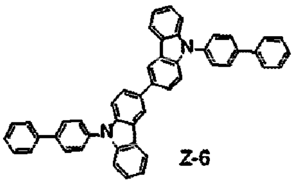

Z-6

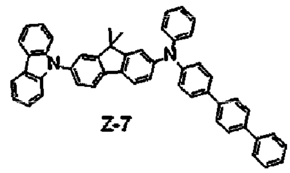

Z-7

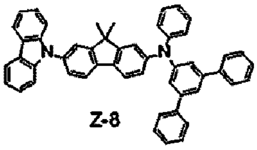

Z-8

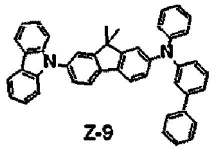

Z-9

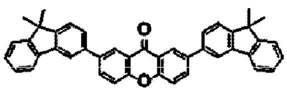

Z-10

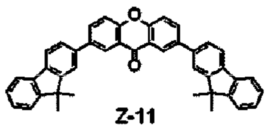

Z-11

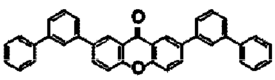

Z-12

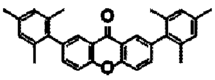

Z-13

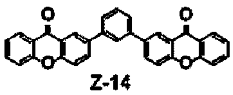

Z-14

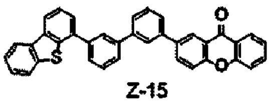

Z-15

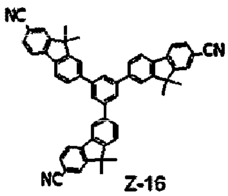

Z-16

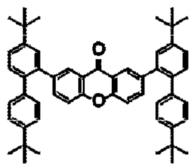

Z-17

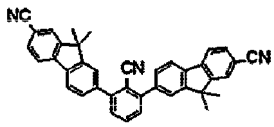

Z-18

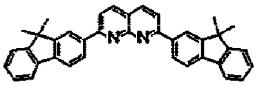

Z-19

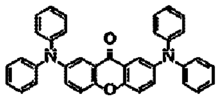

Z-20

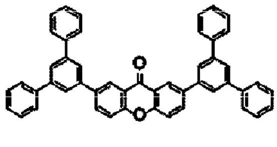

Z-21

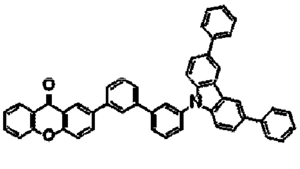

Z-22

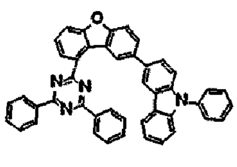

Z-23

Z-1 to Z-23 above can be selected as the first to fourth organic compounds in consideration of HOMO and LUMO thereof. For example, Z-1 to Z-3 are organic compounds which are aromatic hydrocarbons and in which a plurality of fused polycyclic skeletons are bonded together with a carbon-carbon single bond, and can be preferably used as the first organic compound. HOMO, LUMO, and S1 of Z-1 to Z-23 above are shown below. Table 1 shows numerical values of HOMO, LUMO, and S1 of Z-1 to Z-23 above. HOMO is an ionization potential value of a 50 nm thin film of each organic compound prepared by a vacuum evaporation method, the ionization potential value being measured with AC-3 manufactured by RIKEN KEIKI Co., Ltd. LUMO is a value obtained by measuring an absorption spectrum of the same thin film, determining

an optical absorption edge as a bandgap, and then subtracting the bandgap from the ionization potential value. This optical absorption edge corresponds to the lowest excited singlet state of each compound. However, in the case of a phosphorescent material, since the optical absorption edge corresponds to the absorption from the ground state to the triplet state, LUMO determined by the same method is not strictly correct, but can be approximately used.

[Table 3]

| Symbol | HOMO | LUMO | S1 |
|---|---|---|---|
| Z-1 | -6.38 | -2.92 | 3.46 |
| Z-2 | -6.40 | -2.94 | 3.46 |
| Z-3 | -6.33 | -3.05 | 3.28 |
| Z-4 | -5.49 | -2.51 | 2.98 |
| Z-5 | -5.77 | -2.63 | 3.14 |
| Z-6 | -5.73 | -3.15 | 2.58 |
| Z-7 | -5.68 | -2.70 | 2.98 |
| Z-8 | -5.76 | -2.66 | 3.10 |
| Z-9 | -5.85 | -2.71 | 3.14 |
| Z-10 | -6.30 | -3.22 | 3.08 |
| Z-11 | -6.31 | -3.33 | 2.98 |
| Z-12 | -6.43 | -3.30 | 3.13 |
| Z-13 | -6.58 | -3.30 | 3.28 |
| Z-14 | -6.58 | -3.49 | 3.09 |
| Z-15 | -6.33 | -3.13 | 3.20 |
| Z-16 | -6.60 | -3.29 | 3.31 |
| Z-17 | -6.51 | -3.26 | 3.25 |
| Z-18 | -6.77 | -3.42 | 3.35 |
| Z-19 | -6.19 | -3.27 | 2.92 |
| Z-20 | -5.85 | -3.32 | 2.53 |
| Z-21 | -6.55 | -3.42 | 3.13 |
| Z-22 | -6.00 | -2.82 | 3.18 |
| Z-23 | -5.92 | -3.15 | 2.77 |

The organic light-emitting device includes an anode, an organic compound layer, and a cathode that are formed on a substrate. A protective layer, a color filter, etc. may be provided on the cathode. When a color filter is provided, a planarization layer may be provided between the color filter and the protective layer. The planarization layer can be formed of an acrylic resin or the like.

The substrate may be formed of quartz, glass, a silicon wafer, a resin, a metal, or the like. Furthermore, switching devices, such as transistors, and wiring lines may be disposed on the substrate, and an insulating layer may be disposed thereon. The insulating layer may be formed of any material as long as a contact hole can be formed therein to establish the electrical connection between the anode and the wiring lines and as long as insulation from an unconnected wiring line can be ensured. For example, a resin such as polyimide, silicon oxide, or silicon nitride can be used.

The material constituting the anode preferably has a work function that is as large as possible. Examples of the material that can be used include elemental metals such as gold, platinum, silver, copper, nickel, palladium, cobalt, selenium, vanadium, and tungsten; mixtures containing these metals; alloys of combinations thereof; and metal oxides such as tin oxide, zinc oxide, indium oxide, indium tin oxide (ITO), and indium zinc oxide. In addition, conductive polymers, such as polyaniline, polypyrrole, and polythiophene, can also be used.

These electrode substances may be used alone or in combination of two or more thereof. The anode may be formed of a single layer or a plurality of layers.

When the anode is used as a reflective electrode, for example, chromium, aluminum, silver, titanium, tungsten,

molybdenum, an alloy thereof, or a stacked layer thereof can be used. When the anode is used as a transparent electrode, a transparent conductive oxide layer such as an indium tin oxide (ITO) or indium zinc oxide layer may be used; however, the anode is not limited thereto. The electrodes can be formed by using photolithography.

In contrast, the material constituting the cathode preferably has a small work function. Examples of the material of the cathode include alkali metals such as lithium; alkaline earth metals such as calcium; elemental metals such as aluminum, titanium, manganese, silver, lead, and chromium; and mixtures containing these metals. Alloys of these elemental metals can also be used. For example, magnesium-silver, aluminum-lithium, aluminum-magnesium, silver-copper, and zinc-silver can be used. Metal oxides such as indium tin oxide (ITO) can also be used. These electrode substances may be used alone or in combination of two or more thereof. The cathode may have a single-layer structure or a multilayer structure. In particular, silver is preferably used, and a silver alloy is more preferably used to reduce the aggregation of silver. The alloying ratio is not limited as long as the aggregation of silver can be reduced. For example, the ratio may be 1:1.

The cathode is not particularly limited. The cathode may be a conductive oxide layer made of ITO or the like to provide a top-emission device. Alternatively, the cathode may be a reflective electrode made of aluminum (Al) or the like to provide a bottom-emission device. The method for forming the cathode is not particularly limited; however, for example, a DC or AC sputtering method is more preferably used because good film coverage is achieved, and the resistance is easily reduced.

After the formation of the cathode, a protective layer may be provided. For example, a glass member including a moisture absorbent is bonded to the cathode to reduce the permeation of water or the like into an organic compound layer. Thus, the occurrence of display defects can be reduced. In another embodiment, a passivation film composed of silicon nitride or the like may be provided on the cathode to reduce the permeation of water or the like into the organic compound layer. For example, after the formation of the cathode, the resulting substrate may be transferred to another chamber without breaking the vacuum, and a protective layer may be formed thereon by forming a silicon nitride film having a thickness of 2 $\mu$m by a CVD method. After the film deposition by the CVD method, a protective layer may be formed by an atomic layer deposition method (ALD method).

As described above, the organic light-emitting device of the present embodiment may include a fourth light-emitting layer that emits blue light and a charge generation layer between the light-emitting layer stack and the first electrode or the second electrode. The charge generation layer is formed by forming an n/p junction with a p-layer and an n-layer, or by using a p-doped layer and an n-doped layer. For example, in the case of forming a p/n junction alone, an electron injection layer is preferably provided in order to further inject electrons extracted by the p-layer into the electron transport layer. Alternatively, the structure may be n-doped layer/p-doped layer. What kind of combination is suitable for the charge generation layer is not limited in the present embodiment.

For the p-doped layer in the charge generation layer, for example, highly electron-withdrawing HAT-CN or a Lewis acid, such as molybdenum oxide, and an aromatic amine-based compound may be mixed. HAT-CN, molybdenum oxide, and the like are n-type materials, and these materials may be used to form a stacked structure. For the n-doped layer, for example, a material that has a low work function and is easily doped with electrons, such as an alkali metal or alkaline-earth metal, is preferably used. Alternatively, LiF or the like may be combined with a reducing metal thin film to form an electron injection layer, and an n-type layer/p-type layer structure may be formed to generate charges. Whether charges are generated at an interface or generated in advance by doping is not limited in the present embodiment.

When the organic light-emitting device of the present embodiment is used in a tandem device including a charge generation layer, in the carrier injection performed from the first electrode or the second electrode, carries generated in the charge generation layer are injected. Since the light-emitting layer stack according to the present embodiment exhibits yellow light emission, in order to exhibit white light emission, a tandem device with a blue light-emitting device is preferably formed. A white light-emitting device formed in this manner is applicable to a light-emitting light source for a display or an illumination light source. In such a case, since the organic light-emitting device according to the present invention has an improved lifetime, in particular, luminance degradation of green light emission is reduced, and it is possible to provide a white light-emitting device that has a long lifetime and that undergoes less change in the luminance of light of an emission color.

A color filter may be provided for each pixel of the white light-emitting device described above. For example, a color filter provided in consideration of the size of the pixel is disposed on another substrate, and this substrate may be bonded to the substrate having the organic light-emitting devices thereon. Alternatively, a color filter may be formed on the protective layer formed of silicon oxide or the like by photolithographic patterning.

The organic compound layers (such as a hole injection layer, a hole transport layer, an electron-blocking layer, light-emitting layers, a hole-blocking layer, an electron transport layer, and an electron injection layer) that form the organic light-emitting device of the present embodiment are formed by the methods described below.

The organic compound layers that form the organic light-emitting device of the present embodiment can be formed by a dry process, such as a vacuum evaporation method, an ionized deposition method, sputtering, or plasma. Instead of the dry process, it is also possible to employ a wet process involving dissolving a material in an appropriate

solvent, and then forming a layer by a publicly known coating method (for example, spin coating, dipping, a casting method, an LB method, or an ink jet method).

When the layers are formed by a vacuum evaporation method, a coating method using a solution, or the like, the layers are unlikely to undergo, for example, crystallization and have good stability over time. When films are formed by a coating method, the films may also be formed in combination with appropriate binder resins.

Examples of the binder resins include, but are not limited to, polyvinylcarbazole resins, polycarbonate resins, polyester resins, ABS resins, acrylic resins, polyimide resins, phenolic resins, epoxy resins, silicone resins, and urea resins. These binder resins may be used alone as a homopolymer or a copolymer or in combination as a mixture of two or more thereof. Furthermore, publicly known additives such as a plasticizer, an oxidation inhibitor, and an ultraviolet absorbent may be optionally used in combination.

[Applications of organic light-emitting device]

The organic light-emitting device according to the present embodiment can be used as a constituent member of a display apparatus or an illumination apparatus. In addition, the organic light-emitting device is used in, for example, an exposure light source of an electrophotographic image forming apparatus, a backlight of a liquid crystal display apparatus, and a light-emitting apparatus including a color filter on a white light source.

The display apparatus may be an image information processing apparatus that includes an image input unit to which image information is input from an area CCD, a linear CCD, a memory card, or the like and an information processing unit configured to process the input information, and that displays an input image on a display unit.

The display unit included in an imaging apparatus or an ink jet printer may have a touch panel function. The touch panel function may be operated by using infrared radiation, an electrostatic capacitance, a resistive film, or electromagnetic induction, and the operation method is not particularly limited. The display apparatus may be used in a display unit of a multifunctional printer.

Next, a display apparatus according to the present embodiment will be described with reference to the drawings. Fig. 5 is a schematic sectional view illustrating an example of a display apparatus including organic light-emitting devices of the present embodiment and transistors electrically connected to the organic light-emitting devices. Each of the transistors is one example of an active device.

A display apparatus 10 illustrated in Fig. 5 includes a substrate 11 composed of glass or the like and a moistureproof film 12 disposed thereon and configured to protect transistors or an organic compound layer. In the figure, reference numeral 13 denotes a gate electrode composed of a metal, reference numeral 14 denotes a gate insulating film, and reference numeral 15 denotes a semiconductor layer.

Transistors 18 each include the semiconductor layer 15, a drain electrode 16, and a source electrode 17. An insulating film 19 is disposed on top of the transistors 18. An anode 21 constituting an organic light-emitting device is connected to the source electrode 17 through a contact hole 20.

The form of the electrical connection between the electrodes (anode and cathode) included in each organic light-emitting device and the electrodes (source electrode and drain electrode) included in the corresponding one of the transistors is not limited to the form illustrated in Fig. 5. In other words, any form may be employed as long as one of the anode and the cathode is electrically connected to one of the source electrode and the drain electrode of the transistor.

In the display apparatus 10 illustrated in Fig. 5, an organic compound layer 22 is illustrated as a single layer; however, the organic compound layer 22 includes at least the light-emitting layer stack according to the present embodiment and may further include another organic compound layer. A first protective layer 24 and a second protective layer 25 for reducing degradation of the organic light-emitting devices are disposed over cathodes 23.

In the display apparatus 10 illustrated in Fig. 5, the transistors are used as switching devices. Alternatively, metal-insulator-metal (MIM) devices may be used as switching devices.

The transistors 18 used in the display apparatus 10 illustrated in Fig. 5 are not limited to transistors that use a single-crystal silicon wafer but may be thin-film transistor (TFT) devices that have an active layer on an insulating surface of a substrate. Examples of the material of the active layer of the TFT devices include single-crystal silicon, non-single-crystal silicon such as amorphous silicon and microcrystalline silicon, and non-single-crystal oxide semiconductors such as indium zinc oxide and indium gallium zinc oxide.

The transistors 18 included in the display apparatus 10 illustrated in Fig. 5 may be formed inside a substrate such as a Si substrate. The transistors may be transistors formed of low-temperature polysilicon. The expression "formed inside a substrate" as used herein means that transistors are produced by processing a substrate, such as a Si substrate, itself. In other words, having transistors inside a substrate can also be considered that a substrate and transistors are integrally formed.

In the organic light-emitting device according to the present embodiment, the emission luminance is controlled by the transistors 18, which are one example of switching devices, and thus an image can be displayed at respective emission luminance levels by arranging a plurality of organic light-emitting devices in a plane. The switching devices according to the

present embodiment are not limited to transistors and may be active-matrix drivers formed on a substrate such as a Si substrate. The expression "on a substrate" can also be referred to as "inside the substrate". Whether transistors are formed inside a substrate or formed on a substrate is selected on the basis of the size of the display unit. For example, when the size is about 0.5 inches, transistors are preferably formed on a Si substrate.

Fig. 6 is a schematic view illustrating an example of the display apparatus according to the present embodiment. A display apparatus 1000 may include an upper cover 1001 and a lower cover 1009, and a touch panel 1003, a display panel 1005, a frame 1006, a circuit board 1007, and a battery 1008 that are disposed between the upper cover 1001 and the lower cover 1009. The touch panel 1003 and the display panel 1005 are connected to flexible printed circuits FPC 1002 and 1004, respectively. Transistors are printed on the circuit board 1007. The battery 1008 is not necessarily installed unless the display apparatus is a portable apparatus or may be installed in a different position even if the display apparatus is a portable apparatus.

The display apparatus according to the present embodiment may be used in a display unit of an imaging apparatus including an optical unit including a plurality of lenses and an imaging device that receives light that has passed through the optical unit. The imaging apparatus may include a display unit that displays information acquired by the imaging device. The display unit may be a display unit exposed to the outside of the imaging apparatus or a display unit disposed in a finder. The imaging apparatus may be a digital camera or a digital camcorder. The imaging apparatus may also be referred to as a photoelectric conversion apparatus.

Fig. 7A is a schematic view illustrating an example of an imaging apparatus according to the present embodiment. An imaging apparatus 1100 may include a viewfinder 1101, a rear surface display 1102, an operation unit 1103, and a housing 1104. The viewfinder 1101 includes the display apparatus according to the present embodiment. The display apparatus may display not only an image to be captured but also, for example, environmental information and imaging instructions. The environmental information may include, for example, the intensity of external light, the direction of external light, the moving speed of the subject, and the possibility that the subject may hide behind an obstacle.

Since the suitable timing for capturing an image is a very short period of time, it is desirable to display information as quickly as possible. The display apparatus preferably includes the organic light-emitting device of the present embodiment because the response speed is high. The display apparatus that uses the organic light-emitting device can be more suitably used for such apparatuses required to have a high display speed than liquid crystal display apparatuses.

The imaging apparatus 1100 includes an optical unit not illustrated in the drawing. The optical unit includes a plurality of lenses and is configured to form an image on an imaging device contained in the housing 1104. By adjusting the relative positions of the plurality of lenses, the focal point can be adjusted. This operation can also be performed automatically.

The display apparatus according to the present embodiment may include a color filter having red, green, and blue portions. The red, green, and blue portions of the color filter may be arranged in the delta pattern.

The display apparatus according to the present embodiment may be used in a display unit of a portable terminal. In such a case, the display apparatus may have both a display function and an operation function. Examples of the portable terminal include mobile phones such as smart phones, tablets, and head mount displays.

Fig. 7B is a schematic view illustrating an example of an electronic apparatus according to the present embodiment. An electronic apparatus 1200 includes a display unit 1201, an operation unit 1202, and a housing 1203. The housing 1203 may include therein circuits, a printed circuit board having the circuits, a battery, and a communication unit. The operation unit 1202 may be a button or a touch panel-type responsive unit. The operation unit may be a biometric authentication unit configured to, for example, recognize the fingerprints and release the lock. The electronic apparatus that includes a communication unit can also be referred to as a communication apparatus.

Figs. 8A and 8B are schematic views each illustrating an example of the display apparatus according to the present embodiment. Fig. 8A illustrates a display apparatus such as a television monitor or a PC monitor. A display apparatus 1300 includes a base, which supports a frame 1301 and a display unit 1302. The display apparatus according to the present embodiment is used in the display unit 1302. The base 1303 is not limited to the form illustrated in Fig. 8A. The lower side of the frame 1301 may also function as the base. The frame 1301 and the display unit 1302 may be curved. The radius of curvature thereof may be 5,000 mm or more and 6,000 mm or less.

Fig. 8B is a schematic view illustrating another example of the display apparatus according to the present embodiment. A display apparatus 1310 illustrated in Fig. 8B is configured to be foldable and is a so-called foldable display apparatus. The display apparatus 1310 has a first display unit 1311, a second display unit 1312, a housing 1313, and a folding point 1314. Each of the first display unit 1311 and the second display unit 1312 includes the display apparatus according to the present embodiment. The first display unit 1311 and the second display unit 1312 may be a single display apparatus without a joint. The first display unit 1311 and the second display unit 1312 can be separated at the folding point. The first display unit 1311 and the second display unit 1312 may respectively display different images. Alternatively, a single image may be displayed on a set of the first display unit 1311 and the second display unit 1312.

Fig. 9A is a schematic view illustrating an example of an illumination apparatus according to the present

embodiment. An illumination apparatus 1400 may include a housing 1401, a light source 1402, a circuit board 1403, an optical filter 1404 and a light diffusion unit 1405. The light source includes the organic light-emitting device according to the present embodiment. The optical filter 1404 may be a filter that improves the color rendering properties of the light source. The light diffusion unit 1405 can effectively diffuse light emitted from the light source and allow the light to reach a wide range, for example, for lighting up. The optical filter 1404 and the light diffusion unit 1405 may be disposed on the light-emitting side of the illumination. A cover may be optionally disposed on the outermost portion.

The illumination apparatus is, for example, an apparatus that illuminates a room. The illumination apparatus may emit light of a color such as white, natural white, or any other color from blue to red. The illumination apparatus may include a light modulation circuit configured to modulate the light. The illumination apparatus may include the organic light-emitting device according to the present invention and a power supply circuit connected to the organic light-emitting device. The power supply circuit is a circuit configured to convert an AC voltage into a DC voltage. The white is a color having a color temperature of 4,200 K, and the natural white is a color having a color temperature of 5,000 K. The illumination apparatus may include a color filter.

The illumination apparatus according to the present embodiment may include a heat dissipation unit. The heat dissipation unit dissipates heat in the apparatus to the outside of the apparatus. The heat dissipation unit may be formed of, for example, a metal having a high specific heat or liquid silicone.

Fig. 9B is a schematic view of an automobile, which is an example of a moving object according to the present embodiment. The automobile has a tail lamp, which is an example of a lighting fixture. An automobile 1500 has a tail lamp 1501, and the tail lamp may light up when, for example, the brakes are applied.

The tail lamp 1501 includes the organic light-emitting device according to the present embodiment. The tail lamp may include a protective member that protects the organic light-emitting device. The protective member may be composed of any material that has high strength to a certain extent and is transparent, and is preferably composed of polycarbonate or the like. The polycarbonate may be mixed with a furandicarboxylic acid derivative, an acrylonitrile derivative, or the like.

The automobile 1500 may include a car body 1503 and a window 1502 attached to the car body 1503. The window may be a transparent display unless it is a window for checking the front and rear of the automobile. The transparent display includes the organic light-emitting device according to the present embodiment. In such a case, the components, such as the electrodes, of the organic light-emitting device are formed of transparent members.

The moving object according to the present embodiment may be, for example, a ship, an aircraft, or a drone. The moving object may include a body and a lighting fixture attached to the body. The lighting fixture may emit light to indicate the position of the body. The lighting fixture includes the organic light-emitting device according to the present embodiment.

As described above, the use of an apparatus including the organic light-emitting device according to the present embodiment enables an image having good image quality to be stably displayed even for a long time.

EXAMPLES

Organic light-emitting devices including three light-emitting layers and configured to emit yellow light by green light emission and red light emission were prepared. The layer thickness configuration used was Thickness-A in Table 2 above, the first to fourth organic compounds were selected from exemplary compounds Z-1 to Z-23 above, and light-emitting materials used were exemplary compounds RD3, RD1, GD13, and GD9 above. HOMO, LUMO, and S1 of the light-emitting materials are shown in Table 4. The configuration of the light-emitting layer stack prepared in the Examples are shown in Tables 5 and 6.

[Table 4]

| Symbol | Exemplary compound No. | HOMO | LUMO | S1 |
|---|---|---|---|---|
| R-1 (Red) | RD3 | -5.53 | -3.58 | 1.95 |
| R-2 (Red) | RD1 | -5.59 | -3.52 | 2.37 |
| G-1 (Green) | GD13 | -5.08 | -2.71 | 2.40 |
| G-2 (Green) | GD6 | -5.87 | -3.47 | 2.07 |

[Table 5]

| Light-emitting layer stack No. | First organic compound | Fourth organic compound | Second organic compound | Third organic compound | Third light-emitting material | First light-emitting material | Second light-emitting material | Formula [1] | Formula [2] | Formula [3] | Formula [4] | Formula [5] | Formula [6] | Formula [7] | Formula [8] | Formula [9] | Formula [10] |
|---|---|---|---|---|---|---|---|---|---|---|---|---|---|---|---|---|---|
| | | | | | | | | $\lvert S1L1 - S1L2 \rvert < \lvert S1L1 - S1O1 \rvert$ | LUMOO2 > LUMOO3 | S1L3 S1L1 | HOMOL3 < HOMOL1 | LUMOL3 < LUMOL1 | LUMOO1 > LUMOO3 | HOMOO4 > HOMOO1 | HOMOO4 > HOMOO2 | LUMOO1 > LUMOO2 | HOMOO2 > HOMOO1 |
| 1 | Z-1 | Z-8 | Z-17 | Z-21 | R-1 | G-1 | G-1 | satisfied | satisfied | satisfied | satisfied | satisfied | satisfied | satisfied | satisfied | satisfied | not satisfied |
| 2 | Z-1 | Z-4 | Z-21 | Z-21 | R-1 | G-1 | G-1 | satisfied | not satisfied | satisfied | satisfied | satisfied | satisfied | satisfied | satisfied | satisfied | not satisfied |
| 3 | Z-2 | Z-4 | Z-18 | Z-21 | R-1 | G-1 | G-1 | satisfied | not satisfied | satisfied | satisfied | satisfied | satisfied | satisfied | satisfied | satisfied | not satisfied |
| 4 | Z-2 | Z-4 | Z-21 | Z-18 | R-1 | G-1 | G-1 | satisfied | not satisfied | satisfied | satisfied | satisfied | satisfied | satisfied | satisfied | satisfied | not satisfied |
| 5 | Z-2 | Z-4 | Z-13 | Z-12 | R-1 | G-1 | G-1 | satisfied | not satisfied | satisfied | satisfied | satisfied | satisfied | satisfied | satisfied | satisfied | not satisfied |
| 6 | Z-2 | Z-4 | Z-12 | Z-13 | R-1 | G-1 | G-1 | satisfied | not satisfied | satisfied | satisfied | satisfied | satisfied | satisfied | satisfied | satisfied | not satisfied |
| 7 | Z-2 | Z-4 | Z-7 | Z-14 | R-1 | G-1 | G-1 | satisfied | satisfied | satisfied | satisfied | satisfied | satisfied | satisfied | satisfied | not satisfied | satisfied |
| 8 | Z-2 | Z-4 | Z-8 | Z-14 | R-1 | G-1 | G-1 | satisfied | satisfied | satisfied | satisfied | satisfied | satisfied | satisfied | satisfied | not satisfied | satisfied |
| 9 | Z-2 | Z-4 | Z-17 | Z-21 | R-1 | G-1 | G-1 | satisfied | satisfied | satisfied | satisfied | satisfied | satisfied | satisfied | satisfied | satisfied | not satisfied |
| 10 | Z-2 | Z-4 | Z-17 | Z-11 | R-1 | G-1 | G-1 | satisfied | satisfied | satisfied | satisfied | satisfied | satisfied | satisfied | satisfied | satisfied | not satisfied |
| 11 | Z-1 | Z-7 | Z-17 | Z-11 | R-1 | G-1 | G-1 | satisfied | satisfied | satisfied | satisfied | satisfied | satisfied | satisfied | satisfied | satisfied | not satisfied |
| 12 | Z-1 | Z-7 | Z-12 | Z-11 | R-1 | G-1 | G-1 | satisfied | satisfied | satisfied | satisfied | satisfied | satisfied | satisfied | satisfied | satisfied | not satisfied |
| 13 | Z-1 | Z-7 | Z-12 | Z-21 | R-1 | G-1 | G-1 | satisfied | satisfied | satisfied | satisfied | satisfied | satisfied | satisfied | satisfied | satisfied | not satisfied |
| 14 | Z-2 | Z-8 | Z-12 | Z-21 | R-1 | G-1 | G-1 | satisfied | satisfied | satisfied | satisfied | satisfied | satisfied | satisfied | satisfied | satisfied | not satis-fied |

(continued)

| Light-emitting layer stack No. | First organic compound | Fourth organic compound | Second organic compound | Third organic compound | Third light-emitting material | First light-emitting material | Second light-emitting material | Formula [1] | Formula [2] | Formula [3] | Formula [4] | Formula [5] | Formula [6] | Formula [7] | Formula [8] | Formula [9] | Formula [10] |
|---|---|---|---|---|---|---|---|---|---|---|---|---|---|---|---|---|---|
| | | | | | | | | $\lvert S1L1 - S1L2 \rvert < \lvert S1L1 - S1O1 \rvert$ | LUMOO2 > LUMOO3 | S1L3 S1L1 | HOMOL3 < HOMOL1 | LUMOL3 < LUMOL1 | LUMOO1 > LUMOO3 | HOMOO4 > HOMOO1 | HOMOO4 > HOMOO2 | LUMOO1 > LUMOO2 | HOMOO2 > HOMOO1 |
| 15 | Z-1 | Z-4 | Z-3 | Z-21 | R-1 | G-1 | G-1 | satisfied | satisfied | satisfied | satisfied | satisfied | satisfied | satisfied | satisfied | satisfied | satisfied |
| 16 | Z-2 | Z-7 | Z-19 | Z-21 | R-1 | G-1 | G-1 | satisfied | satisfied | satisfied | satisfied | satisfied | satisfied | satisfied | satisfied | satisfied | satisfied |
| 17 | Z-2 | Z-4 | Z-10 | Z-21 | R-1 | G-1 | G-1 | satisfied | satisfied | satisfied | satisfied | satisfied | satisfied | satisfied | satisfied | satisfied | satisfied |
| 18 | Z-1 | Z-4 | Z-20 | Z-21 | R-1 | G-1 | G-1 | satisfied | satisfied | satisfied | satisfied | satisfied | satisfied | satisfied | satisfied | satisfied | satisfied |
| 19 | Z-1 | Z-4 | Z-23 | Z-20 | R-1 | G-1 | G-1 | satisfied | satisfied | satisfied | satisfied | satisfied | satisfied | satisfied | satisfied | satisfied | satisfied |
| 20 | Z-2 | Z-6 | Z-20 | Z-21 | R-1 | G-1 | G-1 | satisfied | satisfied | satisfied | satisfied | satisfied | satisfied | satisfied | satisfied | satisfied | satisfied |
| 21 | Z-2 | Z-4 | Z-20 | Z-21 | R-1 | G-1 | G-1 | satisfied | satisfied | satisfied | satisfied | satisfied | satisfied | satisfied | satisfied | satisfied | satisfied |
| 22 | Z-2 | Z-4 | Z-23 | Z-21 | R-1 | G-1 | G-1 | satisfied | satisfied | satisfied | satisfied | satisfied | satisfied | satisfied | satisfied | satisfied | satisfied |
| 23 | Z-1 | Z-8 | Z-20 | Z-21 | R-1 | G-1 | G-1 | satisfied | satisfied | satisfied | satisfied | satisfied | satisfied | satisfied | satisfied | satisfied | satisfied |
| 24 | Z-2 | Z-7 | Z-20 | Z-21 | R-1 | G-1 | G-1 | satisfied | satisfied | satisfied | satisfied | satisfied | satisfied | satisfied | satisfied | satisfied | satisfied |
| 25 | Z-1 | Z-8 | Z-23 | Z-21 | R-1 | G-1 | G-1 | satisfied | satisfied | satisfied | satisfied | satisfied | satisfied | satisfied | satisfied | satisfied | satisfied |
| 26 | Z-2 | Z-7 | Z-23 | Z-21 | R-1 | G-1 | G-1 | satisfied | satisfied | satisfied | satisfied | satisfied | satisfied | satisfied | satisfied | satisfied | satisfied |
| 27 | Z-1 | Z-6 | Z-23 | Z-21 | R-1 | G-1 | G-1 | satisfied | satisfied | satisfied | satisfied | satisfied | satisfied | satisfied | satisfied | satisfied | satisfied |
| 28 | Z-2 | Z-4 | Z-20 | Z-11 | R-1 | G-1 | G-1 | satisfied | satisfied | satisfied | satisfied | satisfied | satisfied | satisfied | satisfied | satisfied | satisfied |
| 29 | Z-2 | Z-4 | Z-13 | Z-12 | R-1 | R-1 | G-1 | satisfied | not satisfied | not satisfied | not satisfied | not satisfied | satisfied | satisfied | satisfied | satisfied | not satisfied |
| 30 | Z-2 | Z-4 | Z-12 | Z-13 | R-1 | R-1 | G-1 | satisfied | not satisfied | not satisfied | not satisfied | not satisfied | satisfied | satisfied | satisfied | satisfied | not satisfied |

[Table 6]

| Light-emitting layer stack No. | First organic compound | Fourth organic compound | Second organic compound | Third organic compound | Third light-emitting material | First light-emitting material | Second light-emitting material | Formula [1] \|S1L1 - S1L2\| < \|S1L1 - S1O1\| | Formula [2] LUMOO2 > LUMOO3 | Formula [3] S1L3 < S1L1 | Formula [4] HOMOL3 < HOMOL1 | Formula [5] LUMOL3 < LUMOL1 | Formula [6] LUMOO1 > LUMOO3 | Formula [7] HOMOO4 > HOMOO1 | Formula [8] HOMOO4 > HOMOO2 | Formula [9] LUMOO1 > LUMOO2 | Formula [10] HOMOO2 > HOMOO1 |
|---|---|---|---|---|---|---|---|---|---|---|---|---|---|---|---|---|---|
| 31 | Z-2 | Z-4 | Z-17 | Z-11 | R-1 | R-1 | G-1 | satisfied | satisfied | not satisfied | not satisfied | not satisfied | satisfied | satisfied | satisfied | satisfied | not satisfied |
| 32 | Z-1 | Z-7 | Z-17 | Z-11 | R-1 | R-1 | G-1 | satisfied | satisfied | not satisfied | not satisfied | not satisfied | satisfied | satisfied | satisfied | satisfied | not satisfied |
| 33 | Z-2 | Z-4 | Z-13 | Z-12 | G-1 | G-1 | R-1 | satisfied | not satisfied | not satisfied | not satisfied | not satisfied | satisfied | satisfied | satisfied | satisfied | not satisfied |
| 34 | Z-2 | Z-4 | Z-12 | Z-13 | G-1 | G-1 | R-1 | satisfied | not satisfied | not satisfied | not satisfied | not satisfied | satisfied | satisfied | satisfied | satisfied | not satisfied |
| 35 | Z-2 | Z-4 | Z-17 | Z-11 | G-1 | G-1 | R-1 | satisfied | satisfied | not satisfied | not satisfied | not satisfied | satisfied | satisfied | satisfied | satisfied | not satisfied |
| 36 | Z-1 | Z-7 | Z-17 | Z-11 | G-1 | G-1 | R-1 | satisfied | satisfied | not satisfied | not satisfied | not satisfied | satisfied | satisfied | satisfied | satisfied | not satisfied |
| 37 | Z-2 | Z-4 | Z-12 | Z-13 | R-2 | G-2 | G-2 | satisfied | not satisfied | satisfied | not satisfied | satisfied | satisfied | satisfied | satisfied | satisfied | not satisfied |
| 38 | Z-1 | Z-4 | Z-21 | Z-21 | R-2 | G-2 | G-2 | satisfied | not satisfied | satisfied | not satisfied | satisfied | satisfied | satisfied | satisfied | satisfied | not satisfied |
| 39 | Z-2 | Z-7 | Z-23 | Z-21 | R-2 | G-2 | G-2 | satisfied | satisfied | satisfied | not satisfied | satisfied | satisfied | satisfied | satisfied | satisfied | satisfied |
| 40 | Z-1 | Z-6 | Z-23 | Z-21 | R-2 | G-2 | G-2 | satisfied | satisfied | satisfied | not satisfied | satisfied | satisfied | satisfied | satisfied | satisfied | satisfied |
| 41 | Z-2 | Z-4 | Z-20 | Z-11 | R-2 | G-2 | G-2 | satisfied | satisfied | satisfied | not satisfied | satisfied | satisfied | satisfied | satisfied | satisfied | satisfied |
| 42 | Z-2 | Z-4 | Z-13 | Z-12 | R-2 | R-2 | G-2 | satisfied | not satisfied | satisfied | not satisfied | not satisfied | satisfied | satisfied | satisfied | satisfied | not satisfied |
| 43 | Z-2 | Z-4 | Z-12 | Z-13 | R-2 | R-2 | G-2 | satisfied | not satisfied | satisfied | not satisfied | not satisfied | satisfied | satisfied | satisfied | satisfied | not satisfied |
| 44 | Z-2 | Z-4 | Z-17 | Z-11 | R-2 | R-2 | G-2 | satisfied | satisfied | satisfied | not satisfied | not satisfied | satisfied | satisfied | satisfied | satisfied | not satisfied |

(continued)

| Light-emitting layer stack No. | First organic compound | Fourth organic compound | Second organic compound | Third organic compound | Third light-emitting material | First light-emitting material | Second light-emitting material | Formula [1] | Formula [2] | Formula [3] | Formula [4] | Formula [5] | Formula [6] | Formula [7] | Formula [8] | Formula [9] | Formula [10] |
|---|---|---|---|---|---|---|---|---|---|---|---|---|---|---|---|---|---|
| | | | | | | | | \|S1L1 - S1L2\| < \|S1L1 - S1O1\| | LUMOO2 > LUMOO3 | S1L3 < S1L1 | HOMOL3 < HOMOL1 | LUMOL3 < LUMOL1 | LUMOO1 > LUMOO3 | HOMOO4 > HOMOO1 | HOMOO4 > HOMOO2 | LUMOO1 > LUMOO2 | HOMOO2 > HOMOO1 |
| 45 | Z-1 | Z-7 | Z-17 | Z-11 | R-2 | R-2 | G-2 | satisfied | satisfied | satisfied | not satis-fied | not satis-fied | satisfied | satisfied | satisfied | satisfied | not satisfied |
| 46 | Z-2 | Z-4 | Z-13 | Z-12 | G-2 | G-2 | R-2 | satisfied | not satis-fied | satisfied | not satis-fied | not satis-fied | satisfied | satisfied | satisfied | satisfied | not satisfied |
| 47 | Z-2 | Z-4 | Z-12 | Z-13 | G-2 | G-2 | R-2 | satisfied | not satis-fied | satisfied | not satis-fied | not satis-fied | satisfied | satisfied | satisfied | satisfied | not satisfied |
| 48 | Z-2 | Z-4 | Z-17 | Z-11 | G-2 | G-2 | R-2 | satisfied | satisfied | satisfied | not satis-fied | not satis-fied | satisfied | satisfied | satisfied | satisfied | not satisfied |
| 49 | Z-1 | Z-7 | Z-17 | Z-11 | G-2 | G-2 | R-2 | satisfied | satisfied | satisfied | not satis-fied | not satis-fied | satisfied | satisfied | satisfied | satisfied | not satisfied |
| 50 | Z-3 | Z-7 | Z-2 | Z-11 | G-2 | G-2 | R-2 | satisfied | satisfied | satisfied | not satis-fied | not satis-fied | satisfied | satisfied | satisfied | not satis-fied | not satis-fied |
| 51 | Z-3 | Z-7 | Z-1 | Z-11 | G-2 | G-2 | R-2 | satisfied | satisfied | satisfied | not satis-fied | not satis-fied | satisfied | satisfied | satisfied | not satis-fied | not satis-fied |
| 52 | Z-2 | Z-9 | Z-20 | Z-12 | G-2 | G-2 | R-2 | satisfied | not satis-fied | satisfied | not satis-fied | not satis-fied | satisfied | satisfied | not satis-fied | satisfied | satisfied |

(Example 1)

As shown in Table 7, an organic light-emitting device having a bottom-emission structure was prepared in which an anode, a hole injection layer, a hole transport layer, an electron-blocking layer, a light-emitting layer stack, a hole-blocking layer, an electron transport layer, an electron injection layer, and a cathode were sequentially formed on a substrate. The configuration of the light-emitting layer stack is No. 1 in Table 5.

First, an ITO film was formed on a glass substrate and subjected to a desired pattering process to form an ITO electrode (anode). At this time, the ITO electrode had a film thickness of 100 nm. The substrate on which the ITO electrode was formed in this manner was used as an ITO substrate in the following steps. Next, vacuum evaporation was performed by resistance heating in a vacuum chamber to continuously form organic compound layers and an electrode layer shown in Table 7 below on the ITO substrate. At this time, the electrode area of a counter electrode (metal electrode layer, cathode) was adjusted to 3 $mm^2$.

[Table 7]

<table>
<tr><th></th><th colspan="4">Material</th><th>Film thickness (nm)</th></tr>
<tr><td>Cathode</td><td colspan="4">Al</td><td>100</td></tr>
<tr><td>Electron injection layer (EIL)</td><td colspan="4">LiF</td><td>1</td></tr>
<tr><td>Electron transport layer (ETL)</td><td colspan="4">ET2</td><td>15</td></tr>
<tr><td>Hole-blocking layer (HBL)</td><td colspan="4">ET12</td><td>15</td></tr>
<tr><td rowspan="3">Light-emitting layer stack (EML)</td><td>Second light-emitting layer</td><td>Z-1 60 wt%</td><td>Z-21 30 wt%</td><td>G-1 10 wt%</td><td>10</td></tr>
<tr><td>First light-emitting layer</td><td>Z-1 60 wt%</td><td>Z-17 30 wt%</td><td>G-1 10 wt%</td><td>10</td></tr>
<tr><td>Third light-emitting layer</td><td>Z-1 73 wt%</td><td>Z-8 25 wt%</td><td>R-1 2 wt%</td><td>10</td></tr>
<tr><td>Electron-blocking layer (EBL)</td><td colspan="4">HT12</td><td>15</td></tr>
<tr><td>Hole transport layer (HTL)</td><td colspan="4">HT3</td><td>30</td></tr>
<tr><td>Hole injection layer (HIL)</td><td colspan="4">HT16</td><td>5</td></tr>
<tr><td>Anode</td><td colspan="4">ITO</td><td>100</td></tr>
</table>

The durability performance of the obtained organic light-emitting device was measured under a constant current condition. As for measurement apparatuses, specifically, a 6240B power supply manufactured by ADC Corporation was used to cause a current of 50 $mA/cm^2$ to flow through the device, and a change in the emission luminance was measured with a BM7 manufactured by TOPCON CORPORATION to perform a continuous driving test. For durability evaluation, the time (LT70) taken for a luminance degradation to reach 70% was measured. This is expressed as a relative value with respect to the luminance degradation time of Comparative Example 1. A numerical value greater than 1.0 indicates that durability is improved.

(Examples 2 to 36 and Comparative Examples 1 to 16)

Organic light-emitting devices of Examples 2 to 36 and Comparative Examples 1 to 16 were prepared as in Example 1 except that the configuration of the light-emitting layer stack in Table 7 was changed as shown in Table 8. Note that, regardless of the position of the emission color, in the case of green light emission, the light-emitting material concentration was set to 10% by mass, and in the case of red light emission, the light-emitting material concentration was set to 2% by mass. The obtained organic light-emitting devices were evaluated as in Example 1. Table 8 shows the evaluation results.

[Table 8]

| Example No. | Light-emitting layer stack No. | LT70 @50 mA/cm$^2$ |
|---|---|---|
| | | Relative ratio |
| Example 1 | 1 | 1.8 |
| Example 2 | 7 | 1.6 |
| Example 3 | 8 | 1.6 |
| Example 4 | 9 | 1.6 |
| Example 5 | 10 | 1.4 |
| Example 6 | 11 | 1.4 |
| Example 7 | 12 | 1.4 |
| Example 8 | 13 | 1.6 |
| Example 9 | 14 | 1.6 |
| Example 10 | 15 | 2.2 |
| Example 11 | 16 | 1.8 |
| Example 12 | 17 | 1.6 |
| Example 13 | 18 | 1.4 |
| Example 14 | 19 | 1.6 |
| Example 15 | 20 | 1.4 |
| Example 16 | 21 | 1.4 |
| Example 17 | 22 | 1.8 |
| Example 18 | 23 | 1.4 |
| Example 19 | 24 | 1.4 |
| Example 20 | 25 | 1.8 |
| Example 21 | 26 | 1.8 |
| Example 22 | 27 | 1.8 |
| Example 23 | 28 | 1.4 |
| Example 24 | 31 | 1.2 |
| Example 25 | 32 | 1.4 |
| Example 26 | 35 | 1.4 |
| Example 27 | 36 | 1.4 |
| Example 28 | 39 | 1.8 |
| Example 29 | 40 | 1.8 |
| Example 30 | 41 | 1.4 |
| Example 31 | 44 | 1.2 |
| Example 32 | 45 | 1.4 |
| Example 33 | 48 | 1.4 |
| Example 34 | 49 | 1.4 |
| Example 35 | 50 | 2.0 |
| Example 36 | 51 | 1.8 |
| Comparative Example 1 | 2 | 1.0 |
| Comparative Example 2 | 3 | 0.9 |

(continued)

| Example No. | Light-emitting layer stack No. | LT70 @50 mA/cm$^2$ |
|---|---|---|
| | | Relative ratio |
| Comparative Example 3 | 4 | 0.9 |
| Comparative Example 4 | 5 | 0.7 |
| Comparative Example 5 | 6 | 0.8 |
| Comparative Example 6 | 30 | 1.0 |
| Comparative Example 7 | 33 | 1.0 |
| Comparative Example 8 | 34 | 1.0 |
| Comparative Example 9 | 37 | 0.8 |
| Comparative Example 10 | 38 | 1.0 |
| Comparative Example 11 | 42 | 1.0 |
| Comparative Example 12 | 43 | 1.0 |
| Comparative Example 13 | 46 | 1.0 |
| Comparative Example 14 | 47 | 1.0 |
| Comparative Example 15 | 52 | 1.0 |
| Comparative Example 16 | 29 | 1.0 |

As shown in Table 8, a comparison of Comparative Examples 1 to 16 and Examples 35 and 36 shows that the durability performance is improved in Examples. Specifically, it is found that since the energy relationships of the light-emitting layers illustrated in Fig. 1 are satisfied, the recombination regions are dispersed by a hole injection barrier and an electron injection barrier to the second light-emitting layer, and consequently, the concentrated generation of excitons is avoided to improve the durability performance.

In Examples 1 to 14, Examples 24 to 27, and Examples 31 to 34, in addition to the improvement in the durability performance, a decrease in the drive voltage was observed compared with Examples 35 and 36. This is because, as in Fig. 2, in which the formula [9] is satisfied, or Fig. 3, in which the formula [10] is satisfied, an electron injection barrier for dispersing recombination regions is reduced, the injectability is thereby improved, and the drive voltage decreases.

In Examples 10 to 23 and Examples 28 to 30, etc., HOMOs and LUMOs satisfied the relationships illustrated in Fig. 4, the recombination regions were thereby dispersed, and improvement in the durability performance was observed. Furthermore, as compared with Examples 35 and 36, in addition to the improvement in the durability performance, the drive voltage also tended to decrease.

As demonstrated in Examples, it was found that the effect of improving the durability performance was obtained by providing a hole/electron injection barrier from the second light-emitting layer to the first light-emitting layer.

Although not described as Examples, an organic light-emitting device having a combination in which a green light-emitting material was contained in two layers underwent less change in the emission color compared with an organic light-emitting device in which a red light-emitting material was contained in two layers because the luminance degradation time of green light emission was improved.

The present invention is not limited to the above embodiments, and various changes and modifications can be made without departing from the spirit and scope of the present invention. Accordingly, the following claims are accompanied to publicize the scope of the present invention.

This application claims priority based on Japanese Patent Application No. 2022-102325 filed on June 27, 2022, which is hereby incorporated by reference herein in its entirety.

Reference Signs List

18 transistor
10, 1000, 1300, 1310 display apparatus
1100 imaging apparatus
1201, 1302, 1311, 1312 display unit

1203, 1313 housing
1402 light source
1404 optical filter
1405 light diffusion unit

## Claims

**1.** An organic light-emitting device comprising: a first electrode; a first light-emitting layer; a second light-emitting layer in contact with the first light-emitting layer; and a second electrode in this order,

wherein the first light-emitting layer contains a first organic compound, a second organic compound, and a first light-emitting material,
the second light-emitting layer contains the first organic compound, a third organic compound, and a second light-emitting material, and
the organic light-emitting device satisfies formulas [1] and [2] below,

$$|S1L1 - S1L2| < |S1L1 - S1O1| \quad [1]$$

$$LUMOO2 > LUMOO3 \quad [2]$$

S1L1: S1 level energy of the first light-emitting material
S1L2: S1 level energy of the second light-emitting material
S1O1: S1 level energy of the first organic compound
LUMOO2: energy level of lowest unoccupied molecular orbital of the second organic compound
LUMOO3: energy level of lowest unoccupied molecular orbital of the third organic compound.

**2.** The organic light-emitting device according to Claim 1, further comprising a third light-emitting layer disposed between the first electrode and the first light-emitting layer and in contact with the first light-emitting layer,

wherein the third light-emitting layer contains the first organic compound and a third light-emitting material, and the organic light-emitting device satisfies a formula [3] below,

$$S1L3 < S1L1 \quad [3]$$

S1L3: S1 level energy of the third light-emitting material.

**3.** The organic light-emitting device according to Claim 2, wherein the organic light-emitting device satisfies a formula [4] below,

$$HOMOL3 < HOMOL1 \quad [4]$$

HOMOL3: energy level of highest occupied molecular orbital of the third light-emitting material
HOMOL1: energy level of highest occupied molecular orbital of the first light-emitting material.

**4.** The organic light-emitting device according to Claim 2 or 3, wherein the organic light-emitting device satisfies a formula [5] below,

$$LUMOL3 < LUMOL1 \quad [5]$$

LUMOL: energy level of lowest unoccupied molecular orbital of the third light-emitting material
LUMOL1: energy level of lowest unoccupied molecular orbital of the first light-emitting material.

**5.** The organic light-emitting device according to any one of Claims 2 to 4, wherein the third light-emitting layer further contains a fourth organic compound, and the organic light-emitting device satisfies formulas [6] to [8] below,

$$LUMOO1 > LUMOO3 \quad [6]$$

$$HOMOO4 > HOMOO1 \quad [7]$$

$$HOMOO4 > HOMOO2 \quad [8]$$

LUMOO1: energy level of lowest unoccupied molecular orbital of the first organic compound
LUMOO3: energy level of lowest unoccupied molecular orbital of the third organic compound
HOMOO1: energy level of highest occupied molecular orbital of the first organic compound
HOMOO4: energy level of highest occupied molecular orbital of the fourth organic compound
HOMOO2: energy level of highest occupied molecular orbital of the second organic compound.

**6.** The organic light-emitting device according to any one of Claims 1 to 5, wherein the organic light-emitting device satisfies at least one of a formula [9] and a formula [10] below,

$$LUMOO1 > LUMOO2 \quad [9]$$

$$HOMOO2 > HOMOO1 \quad [10]$$

LUMOO1: energy level of lowest unoccupied molecular orbital of the first organic compound
LUMOO2: energy level of lowest unoccupied molecular orbital of the second organic compound
HOMOO1: energy level of highest occupied molecular orbital of the first organic compound
HOMOO2: energy level of highest occupied molecular orbital of the second organic compound.

**7.** The organic light-emitting device according to any one of Claims 1 to 6, wherein the first organic compound is an aromatic hydrocarbon.

**8.** The organic light-emitting device according to Claim 7, wherein the first organic compound has a structure in which a plurality of fused polycyclic skeletons are bonded together with a carbon-carbon single bond.

**9.** The organic light-emitting device according to any one of Claims 2 to 5, wherein in the first light-emitting layer, the second light-emitting layer, and the third light-emitting layer, the first organic compound is a main component.

**10.** The organic light-emitting device according to any one of Claims 2 to 5, wherein the first light-emitting material, the second light-emitting material, and the third light-emitting material are phosphorescent materials.

**11.** The organic light-emitting device according to any one of Claims 2 to 5, wherein one of the first light-emitting material, the second light-emitting material, and the third light-emitting material emits green light, and the others emit red light.

**12.** A display apparatus comprising a plurality of pixels, wherein each of the plurality of pixels includes the organic light-emitting device according to any one of Claims 1 to 11 and a transistor connected to the organic light-emitting device.

**13.** The display apparatus according to Claim 12, further comprising a color filter of three colors of red, green, and blue.

**14.** A photoelectric conversion apparatus comprising: an optical unit including a plurality of lenses; an imaging device that receives light that has passed through the optical unit; and a display unit that displays an image captured by the imaging device,
wherein the display unit includes the organic light-emitting device according to any one of Claims 1 to 11.

**15.** An electronic apparatus comprising: a display unit including the organic light-emitting device according to any one of Claims 1 to 11; a housing provided with the display unit; and a communication unit that is disposed in the housing and communicates with an external unit.

**16.** An illumination apparatus comprising: a light source including the organic light-emitting device according to any one of Claims 1 to 11; and a light diffusion unit or an optical filter that transmits light emitted from the light source.

**17.** A moving object comprising: a lighting fixture including the organic light-emitting device according to any one of Claims 1 to 11; and a body provided with the lighting fixture.

FIG. 1

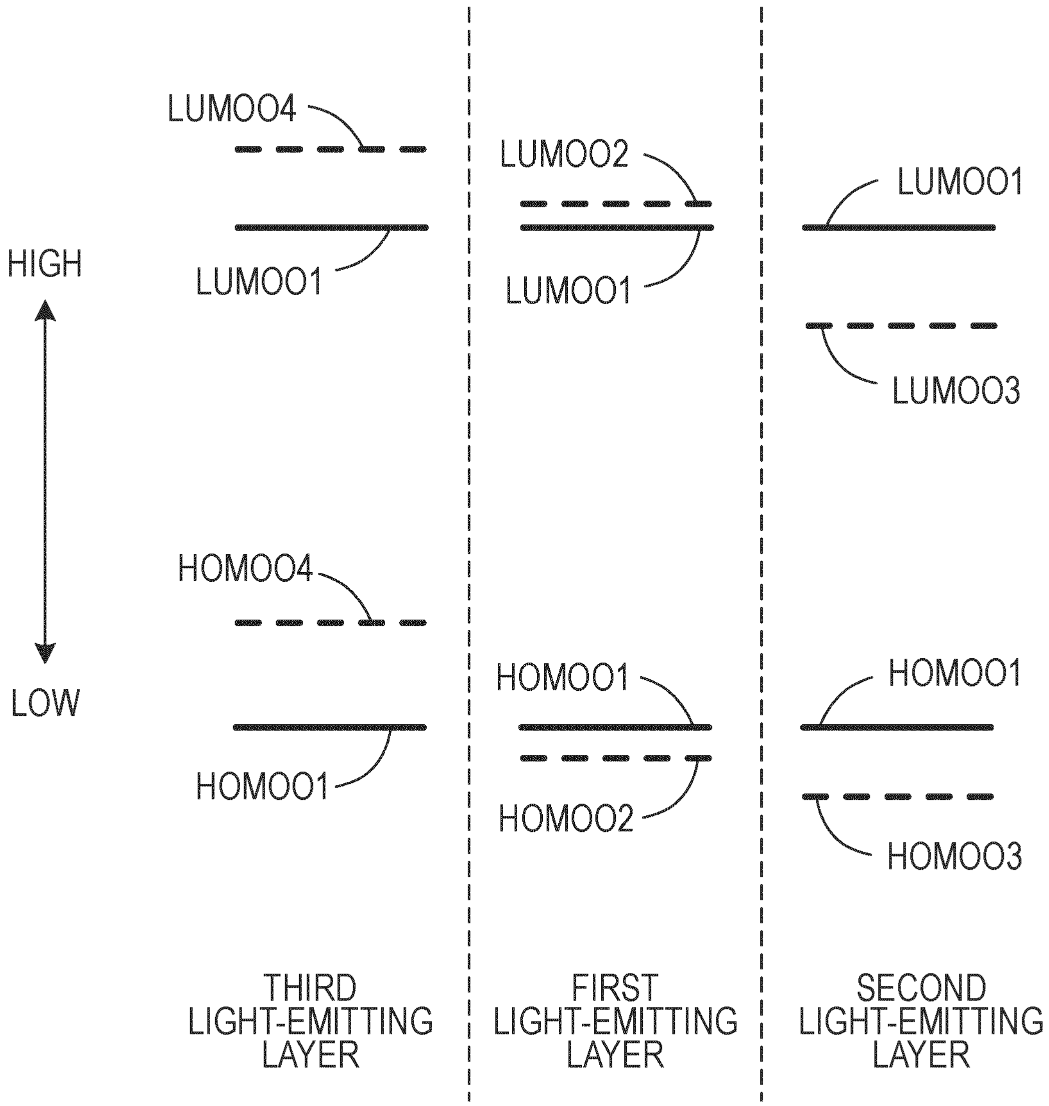
HIGH
LOW
LUMOO4
LUMOO1
HOMOO4
HOMOO1
LUMOO2
LUMOO1
HOMOO1
HOMOO2
LUMOO1
LUMOO3
HOMOO1
HOMOO3
THIRD LIGHT-EMITTING LAYER
FIRST LIGHT-EMITTING LAYER
SECOND LIGHT-EMITTING LAYER

FIG. 2

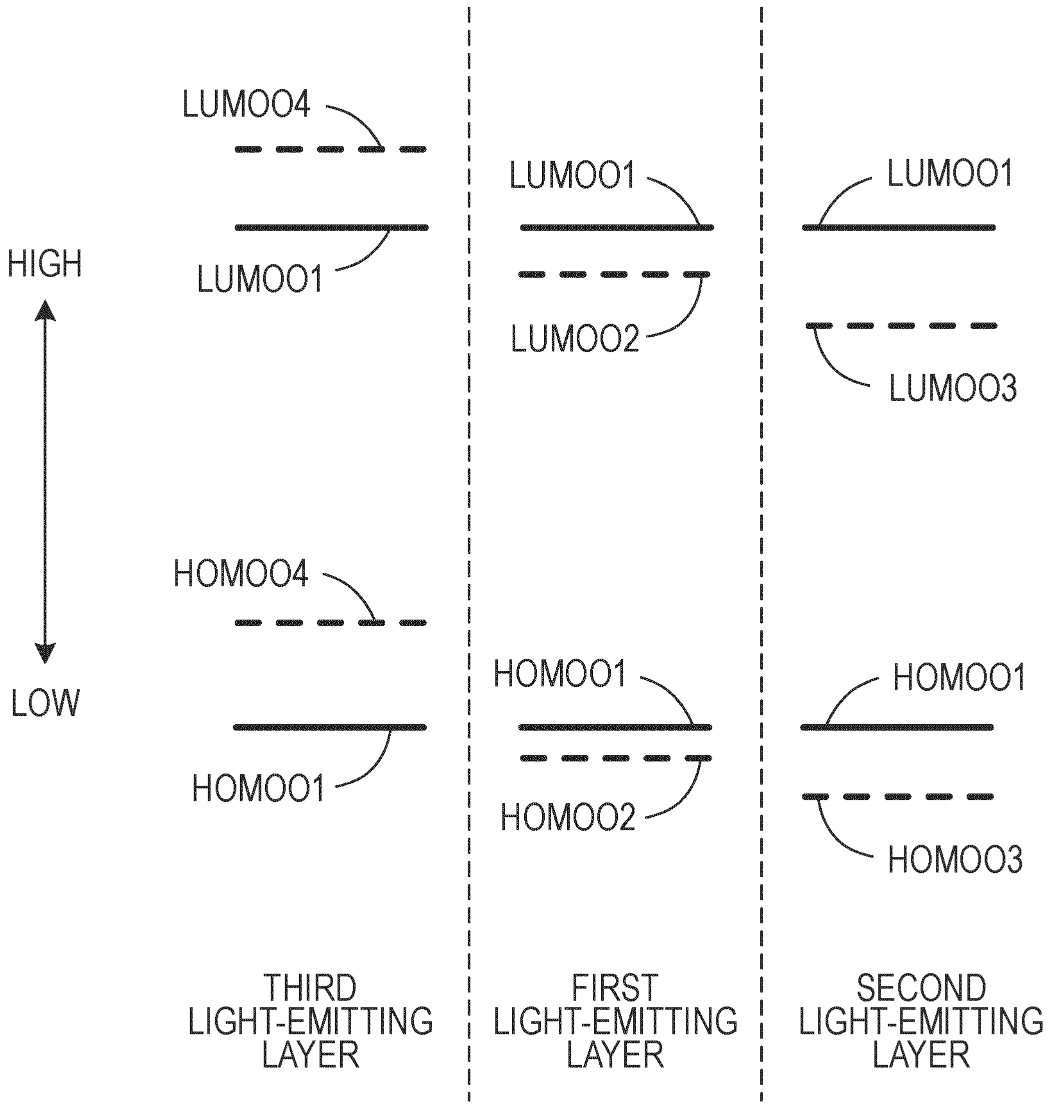
LUMOO4
LUMOO1
HIGH
LOW
LUMOO1
LUMOO2
LUMOO1
LUMOO3
HOMOO4
HOMOO1
HOMOO1
HOMOO2
HOMOO1
HOMOO3
THIRD LIGHT-EMITTING LAYER
FIRST LIGHT-EMITTING LAYER
SECOND LIGHT-EMITTING LAYER

FIG. 3

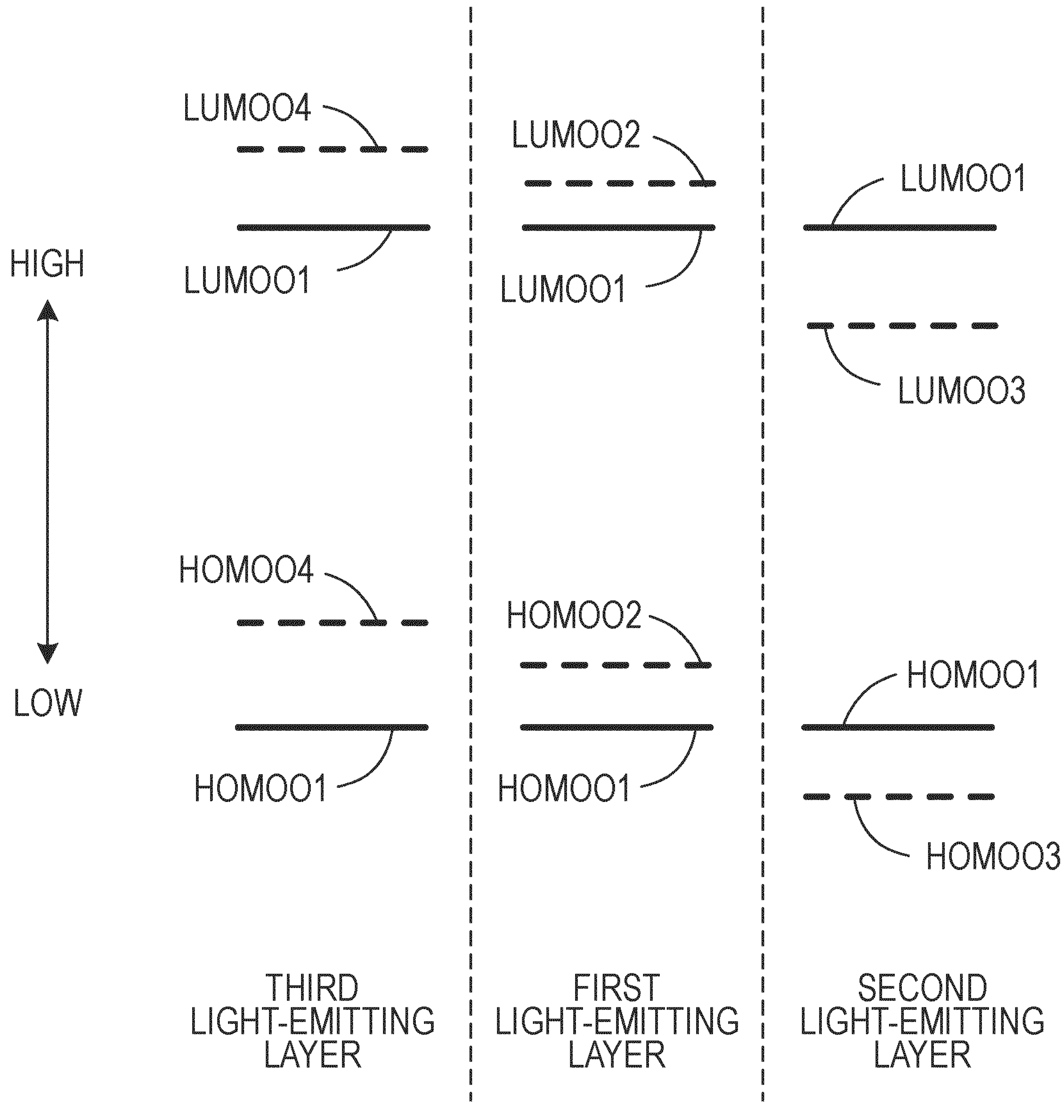
LUMOO4
LUMOO1
LUMOO2
LUMOO1
LUMOO1
LUMOO3
HIGH
LOW
HOMOO4
HOMOO1
HOMOO2
HOMOO1
HOMOO1
HOMOO3
THIRD LIGHT-EMITTING LAYER
FIRST LIGHT-EMITTING LAYER
SECOND LIGHT-EMITTING LAYER

FIG. 4

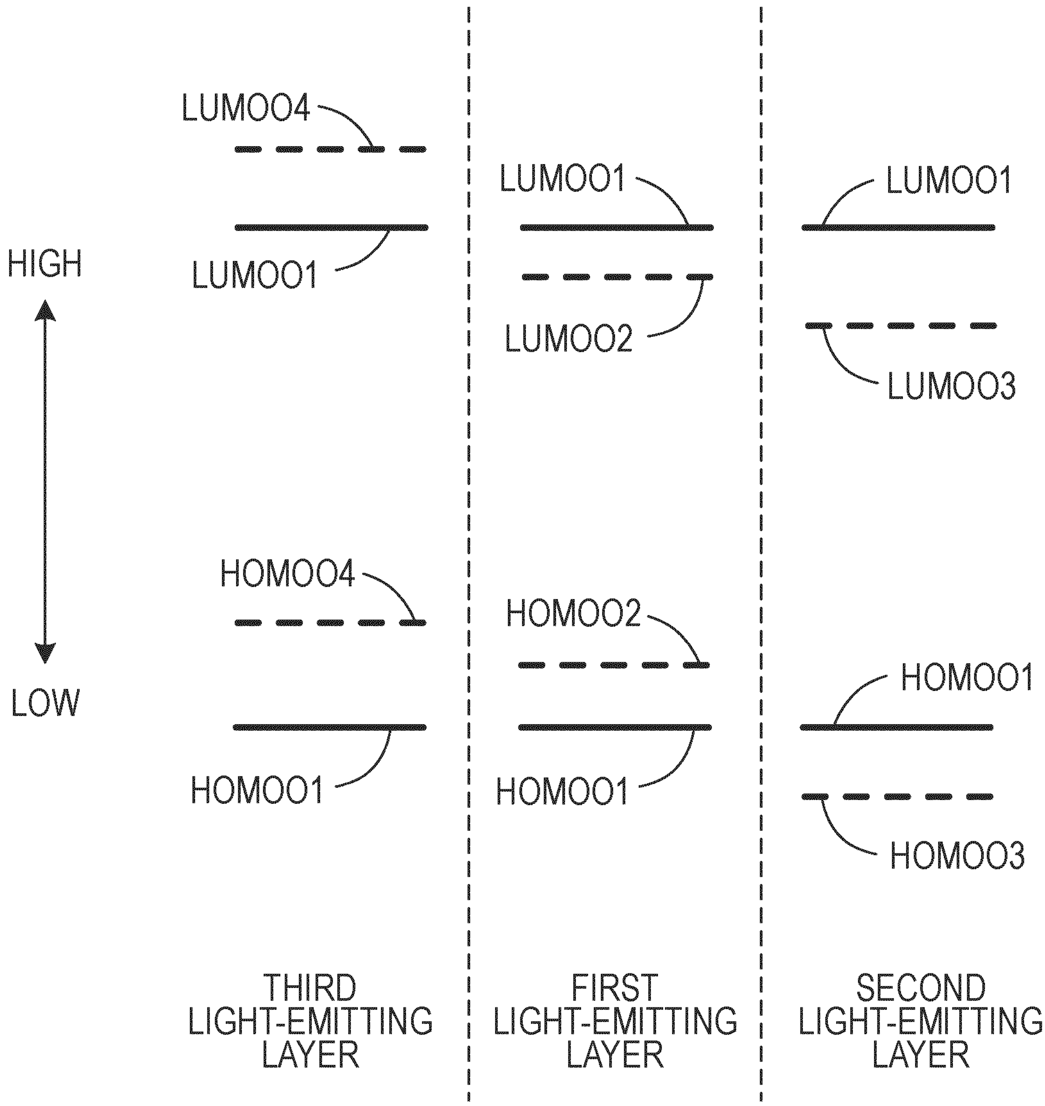
LUMOO4
LUMOO1
HIGH
LOW
HOMOO4
HOMOO1
LUMOO1
LUMOO2
HOMOO2
HOMOO1
LUMOO1
LUMOO3
HOMOO1
HOMOO3
THIRD LIGHT-EMITTING LAYER
FIRST LIGHT-EMITTING LAYER
SECOND LIGHT-EMITTING LAYER

FIG. 5

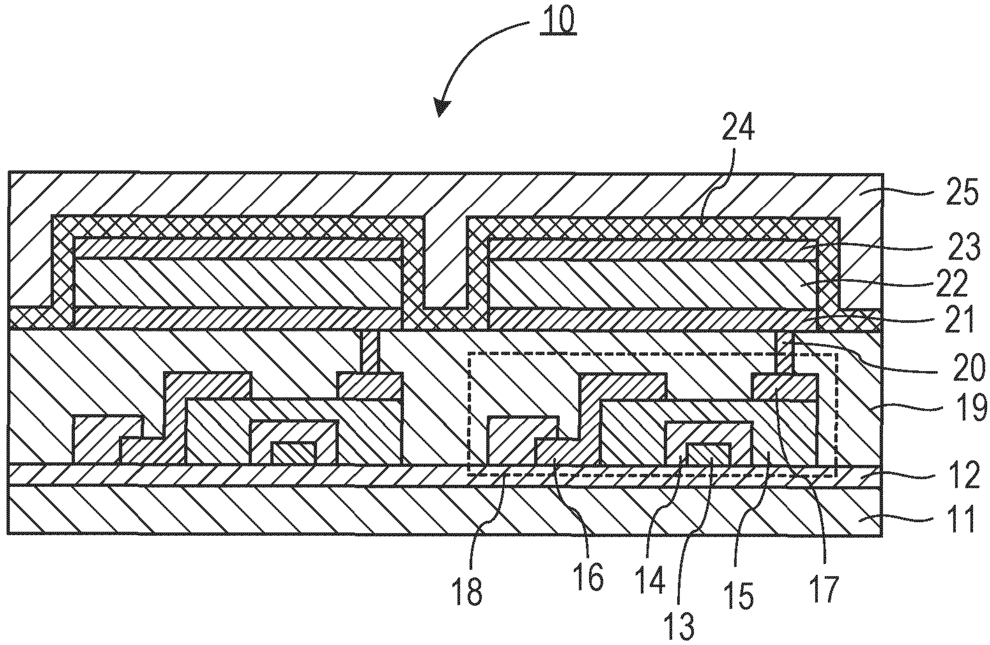

FIG. 6

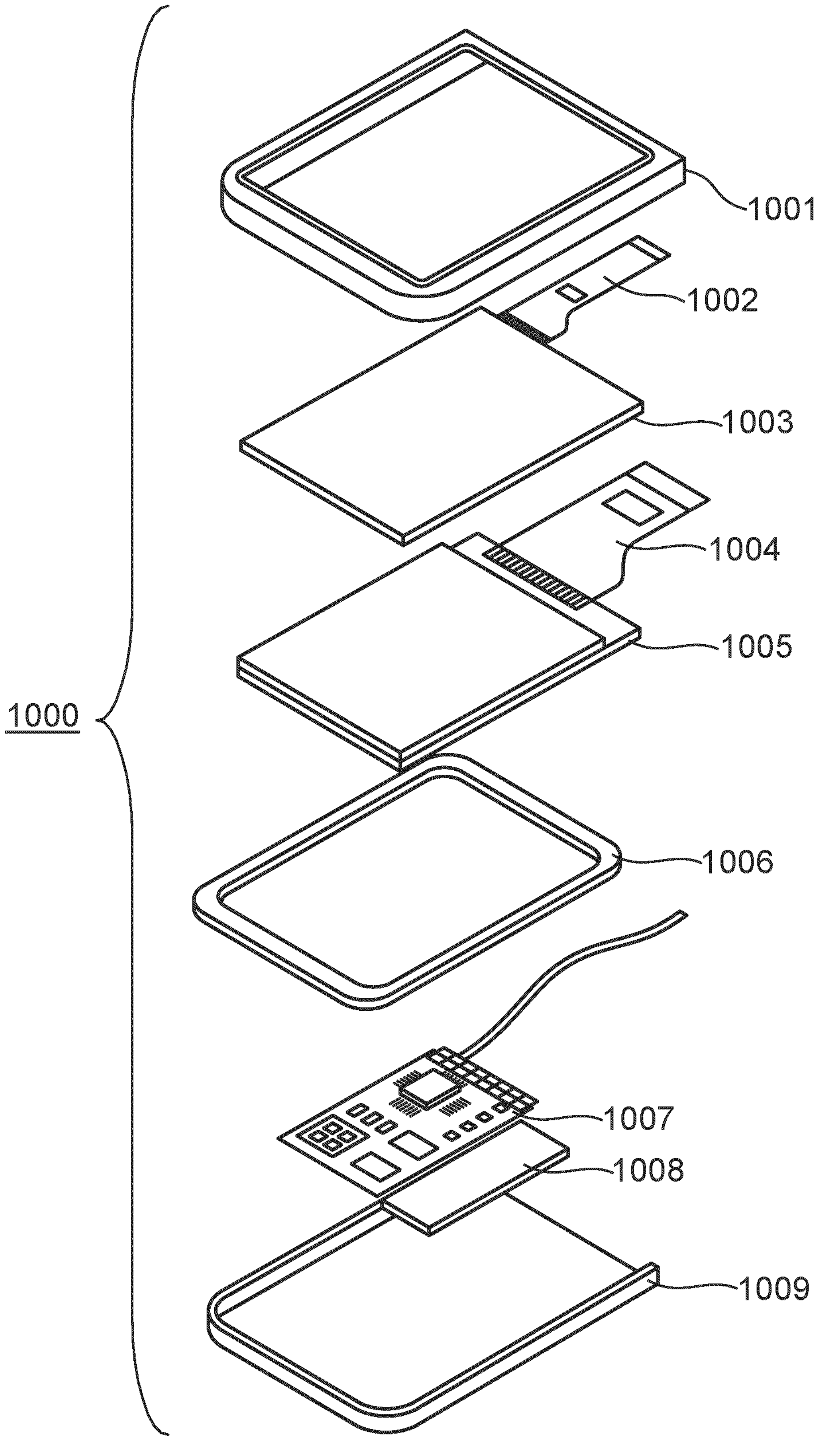

FIG. 7A

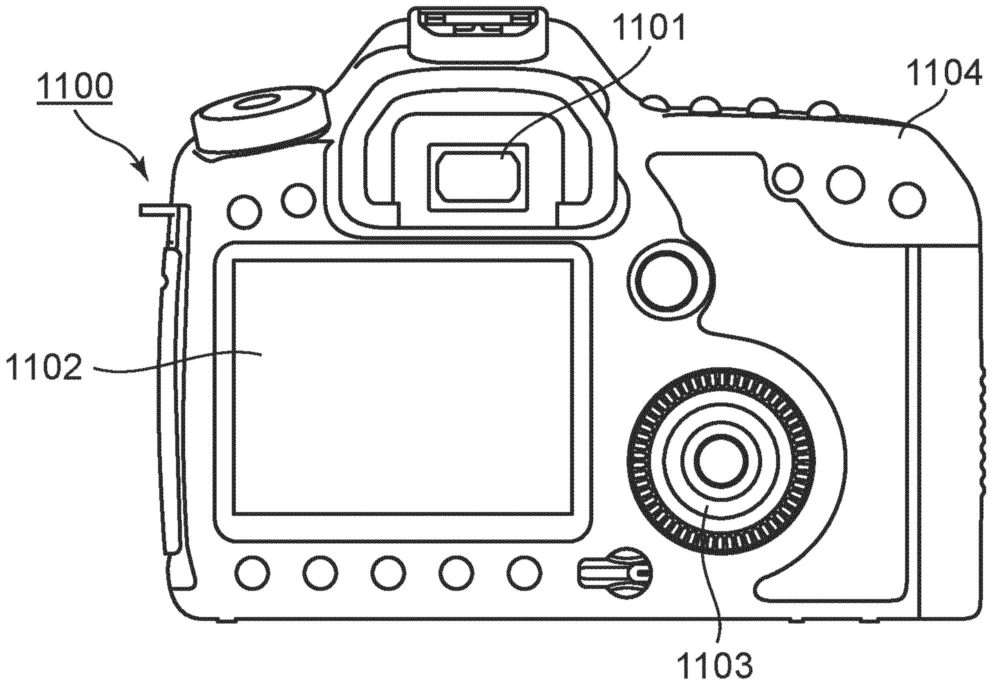


FIG. 7B

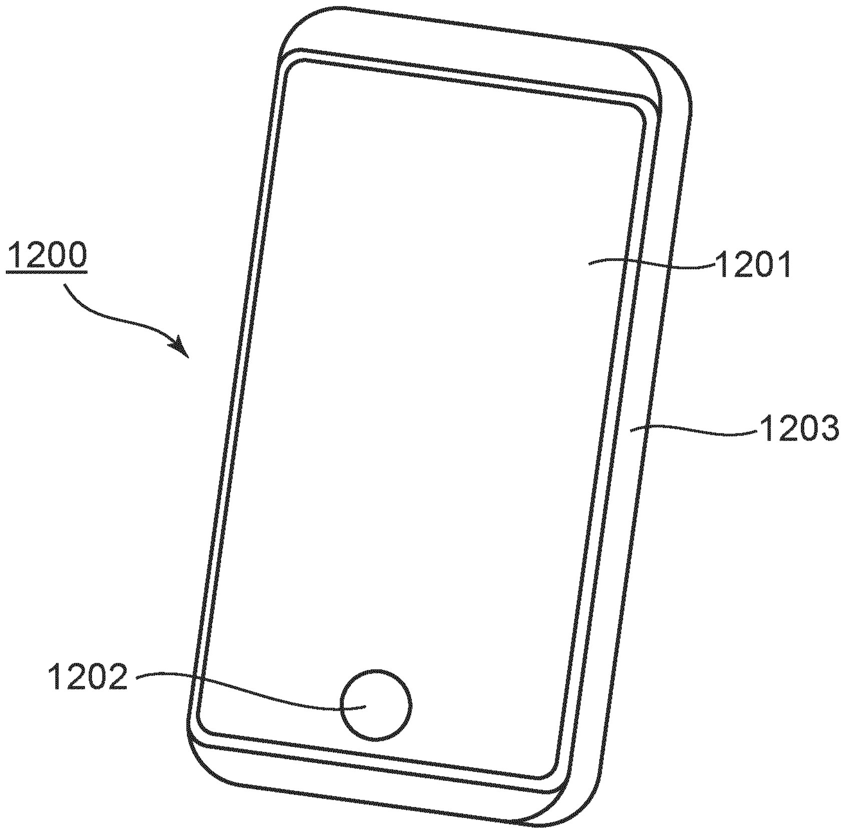

FIG. 8A

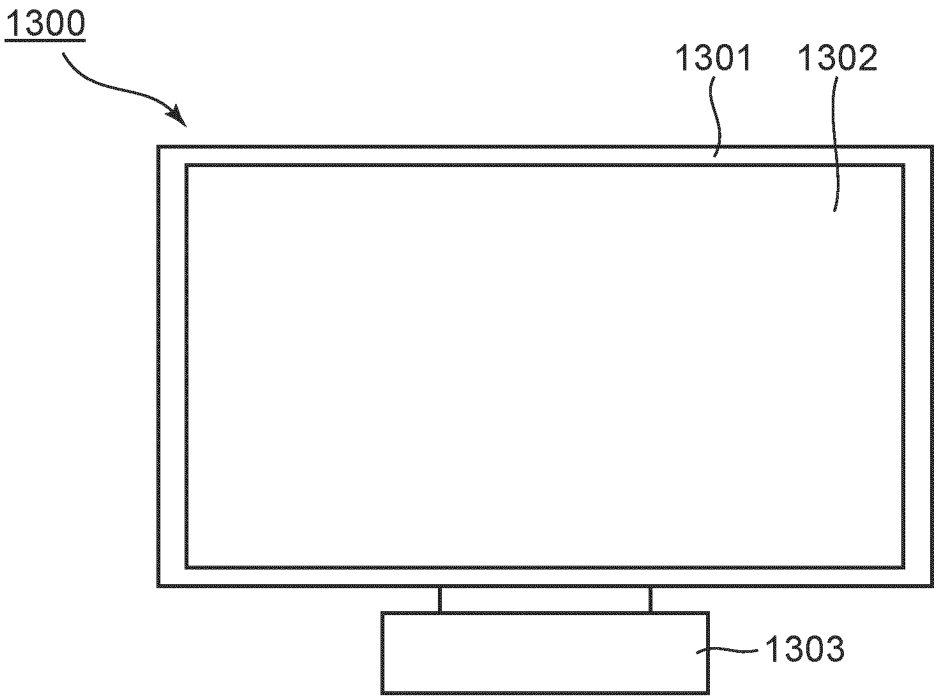


FIG. 8B

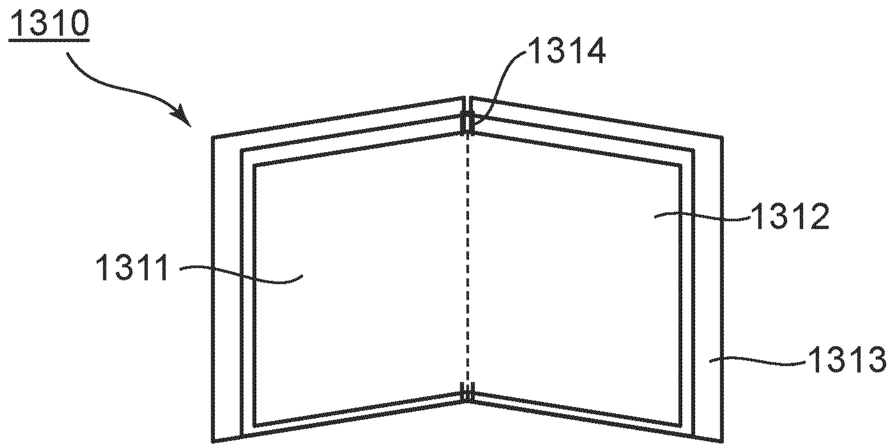

FIG. 9A

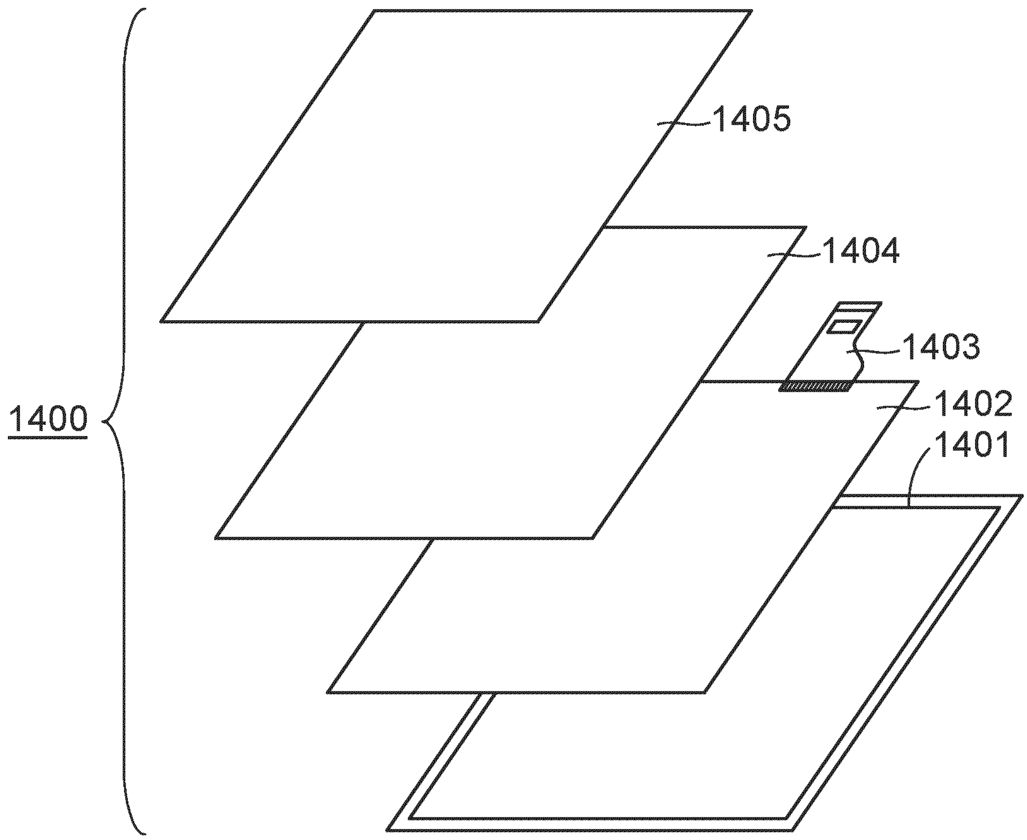


FIG. 9B

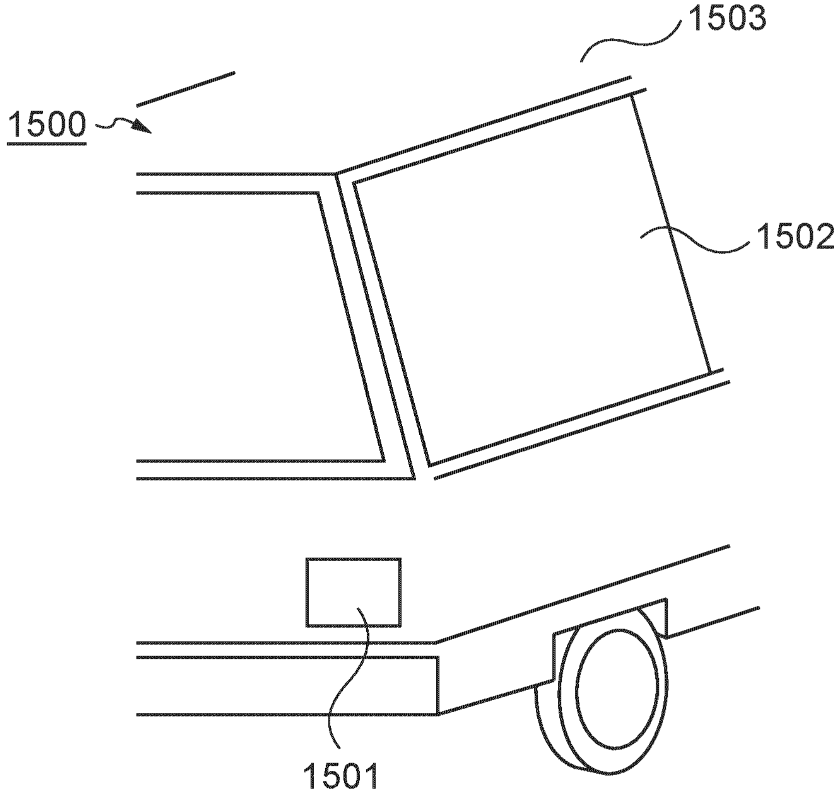

**INTERNATIONAL SEARCH REPORT**

International application No. **PCT/JP2023/020567**

**A. CLASSIFICATION OF SUBJECT MATTER**

***H10K 50/13***(2023.01)i; ***G09F 9/00***(2006.01)i; ***G09F 9/30***(2006.01)i; ***H10K 50/125***(2023.01)i; ***H10K 59/00***(2023.01)i; ***H10K 59/38***(2023.01)i; ***H10K 85/30***(2023.01)i; ***H10K 85/60***(2023.01)i; *H10K 101/10*(2023.01)n; *H10K 101/40*(2023.01)n
FI: H10K50/13; G09F9/00 366G; G09F9/30 349B; G09F9/30 365; H10K50/125; H10K59/00; H10K59/38; H10K85/30; H10K85/60; H10K101:10; H10K101:40

According to International Patent Classification (IPC) or to both national classification and IPC

**B. FIELDS SEARCHED**

Minimum documentation searched (classification system followed by classification symbols)

H10K50/13; G09F9/00; G09F9/30; H10K50/125; H10K59/00; H10K59/38; H10K85/30; H10K85/60; H10K101/10; H10K101/40

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2013-236058 A (SEMICONDUCTOR ENERGY LABORATORY CO., LTD.) 21 November 2013 (2013-11-21) paragraph [0226] | 1-17 |
| A | US 2017/0338432 A1 (UNIVERSAL DISPLAY CORP.) 23 November 2017 (2017-11-23) paragraph [0365], fig. 4-6 | 1-17 |
| A | JP 2015-232994 A (SEMICONDUCTOR ENERGY LABORATORY CO., LTD.) 24 December 2015 (2015-12-24) paragraph [0148] | 1-17 |
| A | JP 2016-110980 A (SEMICONDUCTOR ENERGY LABORATORY CO., LTD.) 20 June 2016 (2016-06-20) fig. 3 | 1-17 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 August 2023** | **15 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2023/020567**

**C. DOCUMENTS CONSIDERED TO BE RELEVANT**

| Category* | Citation of document, with indication, where appropriate, of the relevant passages | Relevant to claim No. |
|---|---|---|
| A | JP 2017-175128 A (SEMICONDUCTOR ENERGY LABORATORY CO., LTD.) 28 September 2017 (2017-09-28)<br>paragraphs [0725], [0735] | 1-17 |
| A | JP 2016-157944 A (SEMICONDUCTOR ENERGY LABORATORY CO., LTD.) 01 September 2016 (2016-09-01)<br>paragraph [0573] | 1-17 |
| A | JP 2019-186521 A (CANON KABUSHIKI KAISHA) 24 October 2019 (2019-10-24)<br>paragraphs [0140]-[0158], fig. 7-10 | 1-17 |
| A | CHANG, Q.-W. et al. A new synthesis method and photophysical properties of Ir(C^N)3 cyclometalated iridium phosphorescent complexes. Bulg. Chem. Commun., 2016, vol. 48, no. 3, pp. 532-534<br>fig. 3 | 1-17 |

Form PCT/ISA/210 (second sheet) (January 2015)

**INTERNATIONAL SEARCH REPORT**
**Information on patent family members**

International application No.
**PCT/JP2023/020567**

| Patent document cited in search report | Publication date (day/month/year) | Patent family member(s) | Publication date (day/month/year) |
|---|---|---|---|
| JP 2013-236058 A | 21 November 2013 | US 2013/0292656 A1<br>paragraph [0240]<br>KR 10-2013-0116185 A<br>CN 103378300 A<br>TW 201347265 A | |
| US 2017/0338432 A1 | 23 November 2017 | US 2020/0083471 A1 | |
| JP 2015-232994 A | 24 December 2015 | US 2015/0155510 A1<br>paragraph [0152]<br>WO 2015/083021 A1<br>TW 201526334 A<br>KR 10-2016-0094378 A<br>CN 105981191 A | |
| JP 2016-110980 A | 20 June 2016 | US 2015/0349284 A1<br>fig. 3<br>WO 2015/181667 A1<br>TW 201608752 A<br>CN 106465506 A<br>KR 10-2017-0013913 A | |
| JP 2017-175128 A | 28 September 2017 | US 2017/0271610 A1<br>paragraphs [0782], [0811]<br>WO 2017/158475 A1<br>TW 201735392 A | |
| JP 2016-157944 A | 01 September 2016 | US 2016/0248032 A1<br>paragraph [0632] | |
| JP 2019-186521 A | 24 October 2019 | US 2019/0305242 A1<br>paragraph [0632], fig. 7-10B<br>CN 110323345 A<br>KR 10-2019-0114795 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008509565 W
- JP 2017152410 A
- JP 2017183291 A
- JP 2022102325 A